# EUROPEAN PATENT APPLICATION

(11) **EP 2 190 035 A1**
(43) Date of publication of application: **26.05.2010**
(21) Application number: 08791818.1
(22) Date of filing: 29.07.2008
(51) Int. Cl.: H01L 33/00, F21S 8/04, F21V 9/08, F21Y 101/02

(54) **LIGHT EMITTING DEVICE, ILLUMINATING APPARATUS AND CLEAN ROOM PROVIDED WITH ILLUMINATING APPARATUS**

(30) Priority: 30.07.2007 JP 2007197994; 31.07.2007 JP 2007199931; 13.05.2008 JP 2008126141
(71) Applicant: Sharp Kabushiki Kaisha, Osaka-shi, Osaka 545-8522 (JP)
(72) Inventor: KAWAKAMI, Junzo, Osaka-shi Osaka 545-8522 (JP); MORIMOTO, Taiji, Osaka-shi Osaka 545-8522 (JP); KOKUBO, Fumio, Osaka-shi Osaka 545-8522 (JP)
(74) Representative: Treeby, Philip David William
(86) International application number: PCT/JP2008/063583
(87) International publication number: WO 2009/017117

(57) **Abstract**

In a light emitting device including a semiconductor light emitting element; a phosphor to be excited by light emitted from the semiconductor light emitting element; and an encapsulating resin including the phosphor and covering the semiconductor light emitting element, the phosphor included in the encapsulating resin suppresses a specific wavelength component for preventing a photosensitive material sensitive to a specific wavelength from reacting. An illuminating apparatus including a plurality of semiconductor light emitting elements includes a control section for suppressing a specific wavelength for preventing a photosensitive material sensitive to the specific wavelength from reacting. A clean room is equipped with such an illuminating apparatus.

## Description

### TECHNICAL FIELD

The present invention relates to a light emitting device using a light emitting diode (hereinafter referred to as an LED), an illuminating apparatus including the light emitting device and a clean room equipped with the illuminating apparatus.

### BACKGROUND ART

Part of fabrication processing for electronic devices such as semiconductor integrated circuits (ICs) and liquid crystal display devices is generally performed in a clean room. In a clean room, air having been cleaned through an HEPA (high-efficiency particulate air) filter provided on a ceiling surface is blown in, and the blown air carries dust floating in the room on air flow so as to be taken out through a floor surface. Through circulation of removing the dust from the air through the HEPA filter again and blowing the resultant air through the ceiling, the air in the clean room is kept clean.

In fabrication processing for fabricating a semiconductor or a liquid crystal display device, what is called patterning, in which a photoresist having a physical property such as solubility changed through exposure to light of a specific wavelength is used for transferring a fine circuit pattern, is generally performed. Most of circuit patterns have a submicron size, and hence, the patterning is performed in a clean room free from dust. On the other hand, the light used for causing a reaction of and curing a photoresist, a UV resin or the like is, for example, g-line (of a wavelength of 436 nm), i-line (of a wavelength of 365 nm), KrF excimer laser (of a wavelength of 248 nm) or ArF excimer laser (of a wavelength of 193 nm), and light of a shorter wavelength is used for a finer circuit pattern. A photoresist, a UV resin or the like is cured through exposure to such light for a short period of time (of several seconds through several tens seconds).

Accordingly, in processing such as photolithography performed in a clean room by using a photosensitive resin of such as a photoresist, for forming a circuit pattern of an IC or a TFT circuit of a liquid crystal display device, it is necessary to cut a specific wavelength of light emitted from an illuminating apparatus provided in the clean room so as not to harmfully affect the exposure using an exposure system.

Specifically, a photosensitive resin such as a photoresist is designed to react to light with a specific wavelength such as the i-line (of a wavelength of 365 nm) or the g-line (of a wavelength of 436 nm) emitted from an exposure system so as to be changed to alkali-soluble or cured, and if the photosensitive resin reacts to light emitted from an illuminating apparatus apart from the exposure system, a circuit cannot be precisely formed. Therefore, in a place such as a clean room where processing using a photosensitive resin is performed, it is necessary to illuminate the room while cutting a wavelength to which the photosensitive resin or the like is sensitive.

Therefore, in a conventional clean room, an illuminating apparatus such as a fluorescent light or a mercury lamp provided with a filter for cutting a specific wavelength is used. As an example of such an illuminating apparatus, Patent Document 1 described below discloses a tubular high-pressure mercury (HID) lamp provided with a light cut filter that is principally made of zinc oxide, includes silver particulates dispersed therein as an additive and cuts transmittance by 50% in a wavelength range of 450 nm through 500 nm.
[Patent Document 1] Japanese Laid-Open Patent Publication No. 2005-221750

### DISCLOSURE OF THE INVENTION

### PROBLEMS TO BE SOLVED BY THE INVENTION

However, a conventional illuminating apparatus such as a fluorescent light or a mercury lamp provided with a filter for cutting a specific wavelength performs illumination while cutting light of a specific wavelength by the filter, and therefore, the illuminance is lowered to 1/3 or 1/4 as compared with the case where the filter is not used in the illumination, resulting in illuminating the clean room with dark yellow light. Accordingly, since a person working in the clean room work for a long period of time in a dark yellow environment, there may arise problems that the safety of the person working in the room may be spoiled, that the working person may be put under mental stress and that the color of a product cannot be distinguished.

The present invention has been devised in consideration of the aforementioned circumstances, and an object of the invention is to provide a light emitting device including an LED and a phosphor to be excited by light emitted from the LED for suppressing a specific wavelength component to which a photosensitive resin or the like is sensitive, an illuminating apparatus using the light emitting device, and a clean room using the illuminating apparatus.

Another object of the invention is to provide an illuminating apparatus including a plurality of LEDs and capable of controlling emission of light of the g-line (of a wavelength of 436 nm) and the i-line (of a wavelength of 365 nm) and a clean room using the illuminating apparatus.

### MEANS FOR SOLVING THE PROBLEMS

The light emitting device of this invention includes a semiconductor light emitting element; and an inhibitor for suppressing a specific wavelength component to which a photosensitive material is sensitive. According to the invention, a specific wavelength component to which a photosensitive resin or the like is sensitive can be selectively suppressed.

The light emitting device of this invention includes a semiconductor light emitting element; a phosphor to be excited by light emitted from the semiconductor light emitting element; and an encapsulating resin including the phosphor and covering the semiconductor light emitting element, and the phosphor included in the encapsulating resin suppresses a specific wavelength component for preventing a photosensitive material sensitive to the specific wavelength component from reacting. According to the invention, it is possible to perform illumination while suppressing a specific wavelength component to which a photosensitive resin or the like is sensitive with degradation of illuminance suppressed.

In the light emitting device of this invention, a wavelength region to which the photosensitive material is sensitive is a blue region of g-line. According to the invention, it is possible to perform illumination while suppressing a photosensitive reaction of a photosensitive resin or the like sensitive to a wavelength in the blue region of the g-line with degradation of illuminance suppressed.

In the light emitting device of this invention, an amount of the phosphor is larger than an amount of phosphor to be included in an encapsulating resin when the light emitting device emits white light. According to the invention, it is possible to perform illumination while suppressing a specific wavelength component to which a photosensitive resin or the like is sensitive with degradation of illuminance suppressed by increasing the amount of the phosphor.

In the light emitting device of this invention, the semiconductor light emitting element is a light emitting diode. According to the invention, since a UV region is not included, it is possible to perform illumination while suppressing a photosensitive reaction of a photosensitive resin or the like with degradation of illuminance suppressed without generating light of a wavelength of i-line.

In the light emitting device of this invention, the light emitting diode is a blue light emitting diode and the phosphor is a yellow phosphor. According to the invention, bright lemon yellow light capable of suppressing a photosensitive reaction of a photosensitive resin or the like can be emitted.

In the light emitting device of this invention, light emitted from the light emitting device has a color coordinate x in an xy chromaticity diagram with a value of 0.4 through 0.45. According to the invention, bright yellow (lemon yellow) light can be emitted. Furthermore, when an illuminating apparatus including the light emitting device of this invention is installed in a clean room or the like, it exhibits effects that the room is kept bright, and that safety of an operator is secured or an operator is not put under stress.

In the light emitting device of this invention, the encapsulating resin includes a red phosphor. According to the invention, the light emitting device attains higher color rendering.

The illuminating apparatus of this invention includes any of the aforementioned light emitting devices. According to the invention, it is possible to perform illumination while suppressing a specific wavelength component to which a photosensitive resin is sensitive with degradation of illuminance suppressed.

The illuminating apparatus of this invention further includes a blocking means for blocking light with the specific wavelength component. According to the invention, light with the specific wavelength component can be blocked not only by the inhibitor but also by the blocking section, and hence, the light with the specific wavelength component can be more definitely reduced.

In the illuminating apparatus of this invention, the blocking means includes a filter for blocking light with the specific wavelength component and a diffuser panel. According to the invention, light with the specific wavelength component can be reduced by the filter as well as glare of a light source can be reduced by diffusing the light with the diffuser panel.

In the illuminating apparatus of this invention, the blocking means includes an air gap between the filter and the diffuser panel. According to the invention, optical loss in the filter of the blocking section can be suppressed as well as the life of the filter can be increased.

The illuminating apparatus of this invention includes a plurality of semiconductor light emitting elements; and a control section for suppressing a specific wavelength for preventing a photosensitive material sensitive to the specific wavelength from reacting. According to the invention, light emission of the plural semiconductor light emitting elements is controlled for illumination so as not to emit light of the g-line (of a wavelength of 436 nm) and the i-line (of a wavelength of 365 nm).

The illuminating apparatus of this invention includes a plurality of semiconductor light emitting elements, and the plurality of semiconductor light emitting elements are controlled for performing illumination with white light and performing illumination in which a specific wavelength is suppressed for preventing a photosensitive material sensitive to the specific wavelength from reacting. According to the invention, bright illumination with high visibility can be performed with white light emission when general deskwork is to be performed, and illumination with a specific wavelength suppressed can be performed when a photosensitive material is to be used, and thus, lighting can be appropriately changed to any of the illuminations depending upon an operation to be performed in a room where the illuminating apparatus is installed.

In the illuminating apparatus of this invention, the plurality of semiconductor light emitting elements include green light emitting diodes and red light emitting diodes, and light obtained by mixing light of the green light emitting diodes and light of the red light emitting diodes is emitted. According to the invention, light obtained by mixing light of a green LED and a red LED is emitted, and it is possible to perform illumination in which emission of light of the i-line of UV and emission of light of the g-line caused in the vicinity of the wavelength (of a 460 nm) of a blue LED are prevented.

In the illuminating apparatus of this invention, the light has a color specified in an xy chromaticity diagram by an x value of 0.38 through 0.44 and a y value of 0.48 through 0.54. According to the invention, light of a green LED and a red LED is mixed for performing illumination with light of a color specified in the xy chromaticity diagram by the x value of 0.38 through 0.44 and the y value of 0.48 through 0.54, and therefore, emission of light of the i-line and the g-line can be prevented and a problem occurring in an environment where the illuminating apparatus is used is reduced.

In the illuminating apparatus of this invention, the plurality of semiconductor light emitting elements further include blue light emitting diodes, and the illuminating apparatus further includes a control section for controlling individual light emission of the green light emitting diodes, the red light emitting diodes and the blue light emitting diodes and combined light emission of the green light emitting diodes, the red light emitting diodes and the blue light emitting diodes. According to the invention, the control section allows individual light emission of a green LED, a red LED and a blue LED or combined light emission of these LEDs in accordance with necessity. For example, in keeping things in a workshop, a green LED, a red LED and a blue LED are all allowed to emit light. On the other hand, in performing a patterning operation using a photosensitive material, a green LED and a red LED alone are allowed to emit light.

In the illuminating apparatus of this invention, a yellow phosphor layer or a red phosphor layer is formed on a part or all of the surface of the plurality of semiconductor light emitting elements. According to the invention, the yellow phosphor layer to be excited by the blue LED for emitting yellow light or the red phosphor layer is applied on a part or all of the surface of the plurality of LEDs, so as to suppress light emission of the g-line caused in the light emission of the blue LED.

The illuminating apparatus of this invention further includes a substrate on which the plurality of semiconductor light emitting elements are mounted; a housing section for housing the substrate; and a translucent section attached on the housing section for transmitting light emitted from the plurality of semiconductor light emitting elements, and the translucent section and the housing section together form a flat body when the translucent section is attached on the housing section. According to the invention, when the translucent section is attached on the housing section, the translucent section and the housing section together form a flat body, and hence, protrusion from an installation surface of the illuminating apparatus is small. Accordingly, air flow is not disturbed in the vicinity of the illuminating apparatus, so that dust can be prevented from being collected in the vicinity of the illuminating apparatus.

The clean room of this invention includes the aforementioned illuminating apparatus. According to the invention, a photosensitive material used in the clean room can be prevented from reacting, the safety of a person working in the room can be secured, and mental stress of a working person can be suppressed. Furthermore, the clean room can attain illumination in which light emission of a plurality of semiconductor light emitting elements is controlled so as not to generate light of, for example, the g-line (of a wavelength of 436 nm) and the i-line (of a wavelength of 365 nm).

### EFFECT OF THE INVENTION

According to the present invention, it is possible to perform illumination while suppressing a specific wavelength component to which a photosensitive resin or the like is sensitive with degradation of illuminance suppressed. Furthermore, since a plurality of semiconductor light emitting elements of different wavelengths are included to be controlled not to emit light of a specific wavelength range such as the g-line (of a wavelength of 436 nm) or the i-line (of a wavelength of 365 nm), in dealing with a photosensitive material such as a photoresist or a UV resin, the photosensitive material may be-prevented from reacting to light emitted from the illuminating apparatus.

### BRIEF DESCRIPTION OF DRAWINGS

FIG. 1 is a schematic plan view of a light emitting device according to Embodiment 1 of the invention.
FIG. 2 is a diagram schematically illustrating the structure of the light emitting device according to Embodiment 1 of the invention from which an encapsulating resin is removed.
FIG. 3 is a schematic cross-sectional view of a principal part of the light emitting device according to Embodiment 1 of the invention.
FIG. 4 is a diagram of change in a coordinate position in a chromaticity diagram of light emitted from a light emitting section caused by changing the amount of yellow phosphor included in an encapsulating resin layer in the light emitting device according to Embodiment 1 of the invention.
FIG. 5 is a graph of change in an optical spectral distribution of the light emitted from the light emitting section caused by changing the amount of yellow phosphor included in the encapsulating resin layer in the light emitting device according to Embodiment 1 of the invention.
FIG. 6 is a graph illustrating change in total luminous flux of the light emitted from the light emitting section caused by changing the amount of yellow phosphor included in the encapsulating resin layer in the light emitting device according to Embodiment 1 of the invention.
FIG. 7A is a graph illustrating the relationship between a weight ratio between the encapsulating resin and the yellow phosphor included in the encapsulating resin layer and a color coordinate x of the light emitted from the light emitting section in the light emitting device according to Embodiment 1 of the invention.
FIG. 7B is a graph illustrating the relationship between the weight ratio between the encapsulating resin and the yellow phosphor included in the encapsulating resin layer and a color coordinate y of the light emitted from the light emitting section in the light emitting device according to Embodiment 1 of the invention.
FIG. 8 is a schematic plan view of an exemplary modification of the light emitting device according to Embodiment 1 of the invention.
FIG. 9 is a schematic plan view of another exemplary modification of the light emitting device according to Embodiment 1 of the invention.
FIG. 10 is an assembling perspective view of an illuminating apparatus according to Embodiment 2 of the invention.
FIG. 11 is an exploded perspective view of the illuminating apparatus according to Embodiment 2 of the invention.
FIG. 12 is a schematic plan view of a substrate included in the illuminating apparatus according to Embodiment 2 of the invention on which a light emitting device is mounted.
FIG. 13 is an exploded perspective view of an illuminating apparatus according to Embodiment 3 of the invention.
FIG. 14 is a schematic plan view of a substrate included in the illuminating apparatus according to Embodiment 3 of the invention on which a light emitting device is mounted.
FIG. 15 is a perspective view of lighting equipment obtained by connecting the illuminating apparatus according to Embodiment 2 or 3 of the invention to a power supply unit or another illuminating apparatus.
FIG. 16 is an assembling perspective view of a principal part of an illuminating apparatus according to Embodiment 4 of the invention.
FIG. 17 is an exploded perspective view of the principal part of the illuminating apparatus according to Embodiment 4 of the invention.
FIG. 18 is a cross-sectional view of a filter diffuser panel included in the illuminating apparatus according to Embodiment 4 of the invention.
FIG. 19A is a diagram explaining a path of light passing through the filter diffuser panel with no air gap provided.
FIG. 19B is a diagram explaining a path of light passing through the filter diffuser panel with an air gap provided.
FIG. 20 is a block diagram illustrating the structure of lighting equipment including a plurality of illuminating apparatuses according to Embodiment 5 of the invention.
FIG. 21 is a perspective view illustrating the appearance of a lighting section of the illuminating apparatus according to Embodiment 5 of the invention.
FIG. 22A is a plan view of the illuminating apparatus according to Embodiment 5 of the invention from which a cover of the lighting section is removed.
FIG. 22B is a vertical cross-sectional view of the illuminating apparatus according to Embodiment 5 of the invention from which the cover of the lighting section is removed.
FIG. 22C is a lateral cross-sectional view of the illuminating apparatus according to Embodiment 5 of the invention from which the cover of the lighting section is removed.
FIG. 23 is an exploded perspective view of the illuminating apparatus according to Embodiment 5 of the invention from which the cover of the lighting section is removed.
FIG. 24A is a diagram illustrating a state attained before handling of a clipping member in an exchange operation for a substrate.
FIG. 24B is a diagram illustrating a state attained after handling of the clipping member in the exchange operation for a substrate.
FIG. 25 is a perspective view of an LED, a substrate, a connecting member of a lighting section of an illuminating apparatus according to Embodiment 6 of the invention.
FIG. 26 is a graph of a spectrum obtained by turning on the lighting section of the illuminating apparatus according to Embodiment 6 of the invention.
FIG. 27 is a perspective view of an LED module, a substrate and a connecting member of a lighting section of an illuminating apparatus according to Embodiment 7 of the invention.
FIG. 28 is a transparent perspective view illustrating the inside of a clean room equipped with an illuminating apparatus according to Embodiment 8 of the invention.
FIG. 29 is a graph of spectra obtained by turning on a red LED, a green LED and a blue LED.
FIG. 30 is a graph of spectra obtained by turning on a red LED and a green LED alone.

### EXPLANATION OF CODES

- 10, 30, 40, 71: light emitting device
- 11: substrate
- 12: blue LED
- 13: yellow phosphor
- 15: encapsulating resin layer
- 50, 70, 80, 100: LED illuminating apparatus
- 113: filter diffuser panel
- 131: diffuser panel
- 132: cut filter
- 133: air gap
- 201: lighting section
- 202: housing section
- 203: globe
- 205, 205A, 205B: LED
- 206: substrate
- 208: connecting member
- 210: main body (flat body)
- 220: control section

### BEST MODE FOR CARRYING OUT THE INVENTION

Now, a light emitting device (a luminous module) using an LED, an LED illuminating apparatus including the light emitting device, and a clean room equipped with the LED illuminating apparatus according to the present invention will be described with reference to the accompanying drawings.

### (EMBODIMENT 1)

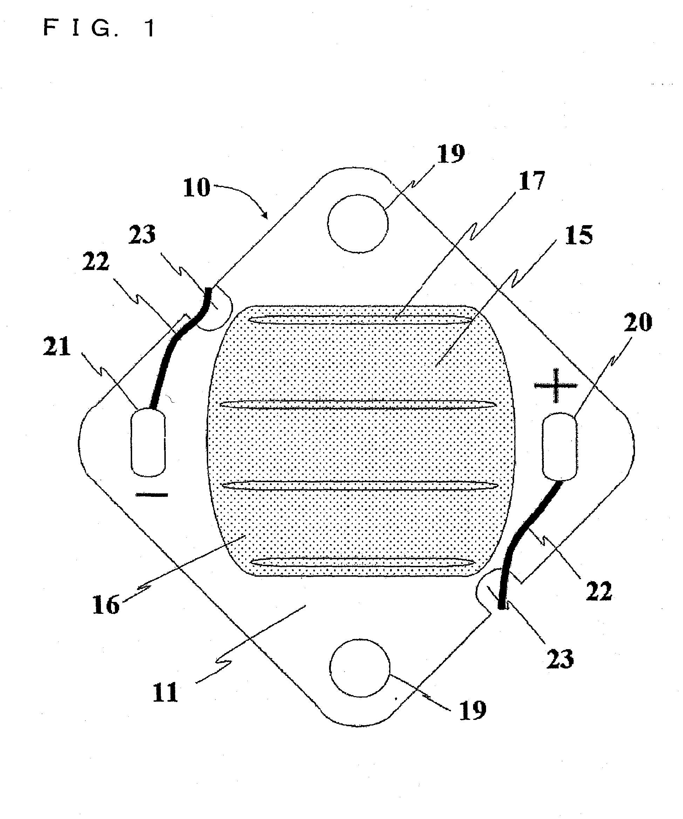

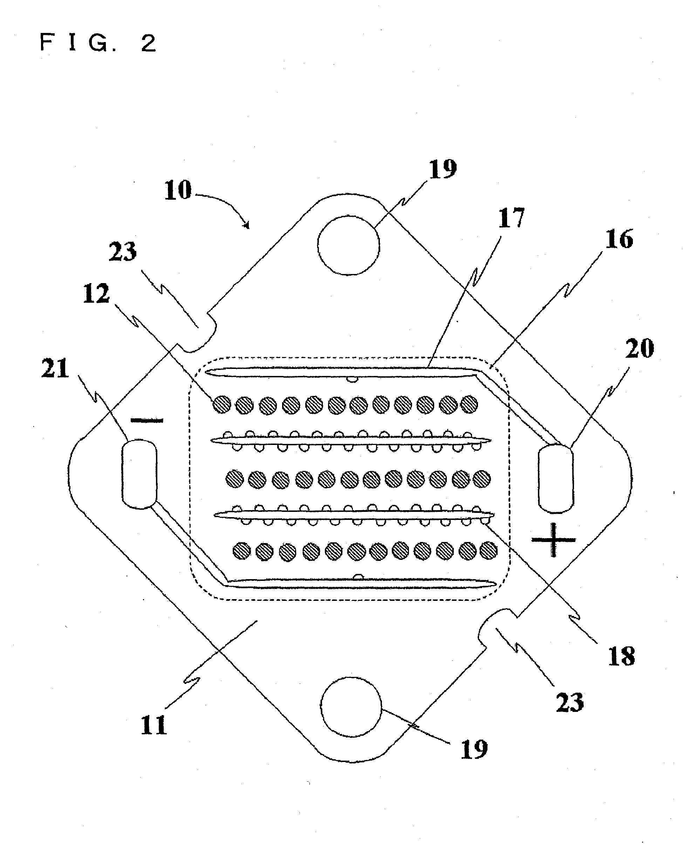

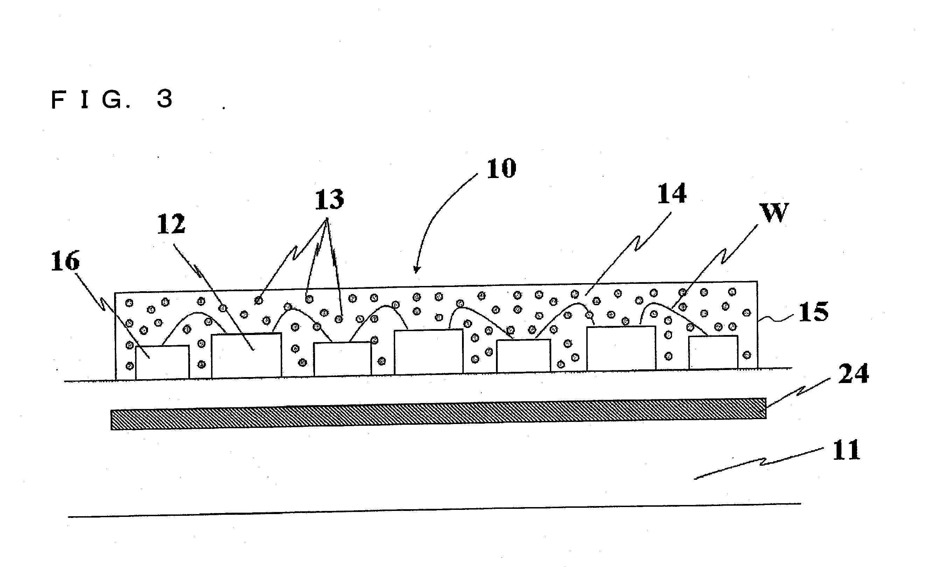

FIG. 1 is a schematic plan view of a light emitting device according to Embodiment 1. FIG. 2 is a schematic diagram illustrating the structure of the light emitting device of Embodiment 1 from which an encapsulating resin is removed. FIG. 3 is a schematic cross-sectional view of a principal part of the light emitting device of Embodiment 1.

Referring to FIGS. 1 and 2, a light emitting device 10 includes a substrate 11 in a rectangular shape with rounded corners made of ceramic such as aluminum oxide (alumina) and a plurality of blue LEDs 12 arranged in three parallel rows mounted on the substrate 11. The group of the mounted LEDs 12 is covered with and encapsulated in an encapsulating resin layer 15 made of an encapsulating resin 14 of epoxy resin or the like including a yellow phosphor 13 that emits yellow light when excited by light emitted from the LED 12. The plural blue LEDs 12 and the encapsulating resin layer 15 including the yellow phosphor 13 and the encapsulating resin 14 together form a light emitting section 16. On the substrate 11, wiring patterns 17 are formed in parallel by photoetching or the like, and each of the plural LEDs 12 is fixed with a resin such as epoxy resin correspondingly to an LED mounting estimation mark 18 formed along the wiring pattern 17.

Furthermore, on two pairs of opposing corners of the rectangular substrate 11, a pair of screwing parts 19 for fixing the substrate 11 on a base (not shown) of an illuminating apparatus or the like and a pair of external connection land parts composed of a positive electrode external connection land 20 and a negative electrode external connection land 21 for supplying a direct current to the LEDs 12 from an external power source (not shown) are respectively provided. The positive electrode external connection land 20 and the negative electrode external connection land 21 are connected to external wires 22, and external wire notches 23 through which the external wires 22 run are provided on two opposing sides of the substrate 11.

Referring to FIG. 3, the plural LEDs 12 are electrically connected to the wiring patterns 17 through wires W, and a reflection layer 24 made of an alloy such as Ag-Nd for reflecting light emitted from the LEDs 12 and entering the substrate 11 is formed within the substrate 11 by sputtering. The substrate 11 has a thickness of approximately 1 mm, and the reflection layer 24 has a thickness of approximately 0.1 mm. When the reflection layer 24 has a thickness of approximately 0. 1 mm, it exhibits the effect as the reflection layer more definitely.

Next, the blue LED 12, the yellow phosphor 13 and the encapsulating resin 14 included in the light emitting section 16 will be described in detail. In this embodiment, a blue LED including a gallium nitride-based compound semiconductor formed on a sapphire substrate is used as the blue LED 12, and a BOS phosphor, (BaSr)₂SiO₂: Eu2+ is used as the material for the yellow phosphor 13 that emits yellow light when excited by blue light. Instead, a blue LED including a gallium nitride-based compound semiconductor formed on a GaN substrate or a blue LED including a ZnO (Zinc oxide)-based compound semiconductor may be used as the blue LED 12. Also, it goes without saying that an LED including an InGaAlP-based or AlGaAs-based compound semiconductor may be used instead. Alternatively, a Ce:YAG (cerium activated yttrium aluminum garnet) phosphor may be used as the material for the yellow phosphor 13 that emits yellow light when excited by blue light.

As the material for the encapsulating resin 14, a transparent resin with weather resistance such as urea resin or silicone resin or a translucent inorganic material with light resistance such as silica sol or glass may be suitably used apart from the epoxy resin. Furthermore, a dispersing agent may be included in the encapsulating resin together with the phosphor. As a specific dispersing agent, barium titanate, titanium oxide, aluminum oxide, silicon oxide, calcium carbonate, silicon dioxide or the like may be suitably used.

Next, the dependency of light emitted from the light emitting section 16 on the amount of yellow phosphor 13 will be described on the basis of experimental results for change in a coordinate position in a CIE chromaticity diagram, change in a spectral distribution and change in total luminous flux of the light emitted from the light emitting section 16 obtained by changing the amount of yellow phosphor 13 included in the encapsulating resin layer 15.

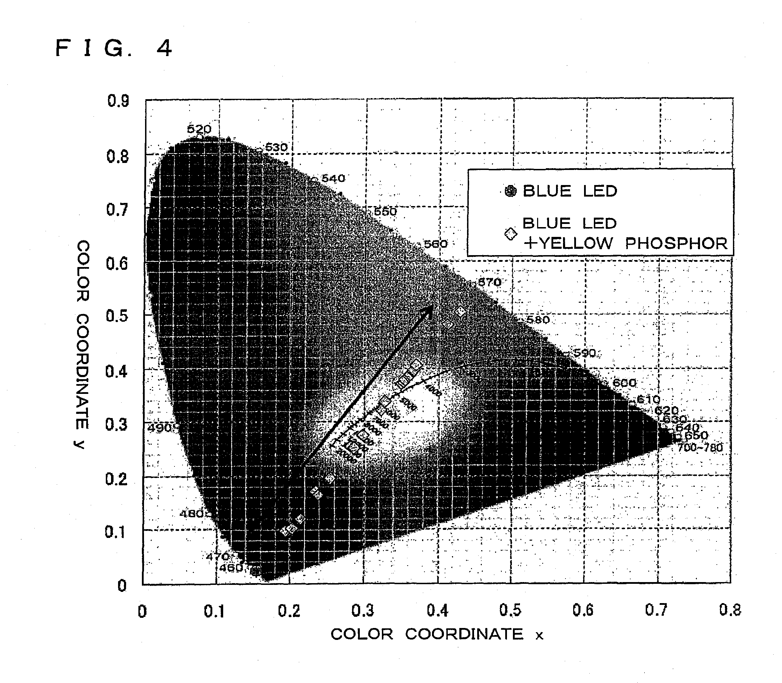

FIG. 4 is a diagram illustrating change (movement) in a coordinate position in the chromaticity diagram of the light emitted from the light emitting section 16 obtained by changing the amount of yellow phosphor 13 included in the encapsulating resin layer 15. In this drawing, a point indicated by a symbol ○ corresponds to a coordinate position obtained by emitting light from the blue LED 12 alone, and a plurality of points each indicated by a symbol 0 correspond to coordinate positions of composite light of light from the blue LED 12 and light from the yellow phosphor 13 in samples in which the amount of yellow phosphor 13 is changed.

As the amount of yellow phosphor 13 included in the encapsulating resin layer 15 is increased, the probability of collision of the light emitted from the blue LED 12 against the yellow phosphor 13 is increased, and therefore, the intensity of yellow light caused through excitement of the yellow phosphor 13 tends to be increased and the intensity of the blue light tends to be reduced because it is blocked by the yellow phosphor 13. Accordingly, the yellow phosphor 13 functions as an inhibitor against the light of a blue region emitted from the blue LED 12, and hence, in the chromaticity diagram of FIG. 4, the coordinate position of the light emitted from the light emitting section 16 is moved from the blue region to a yellow region (in a direction indicated with an arrow).

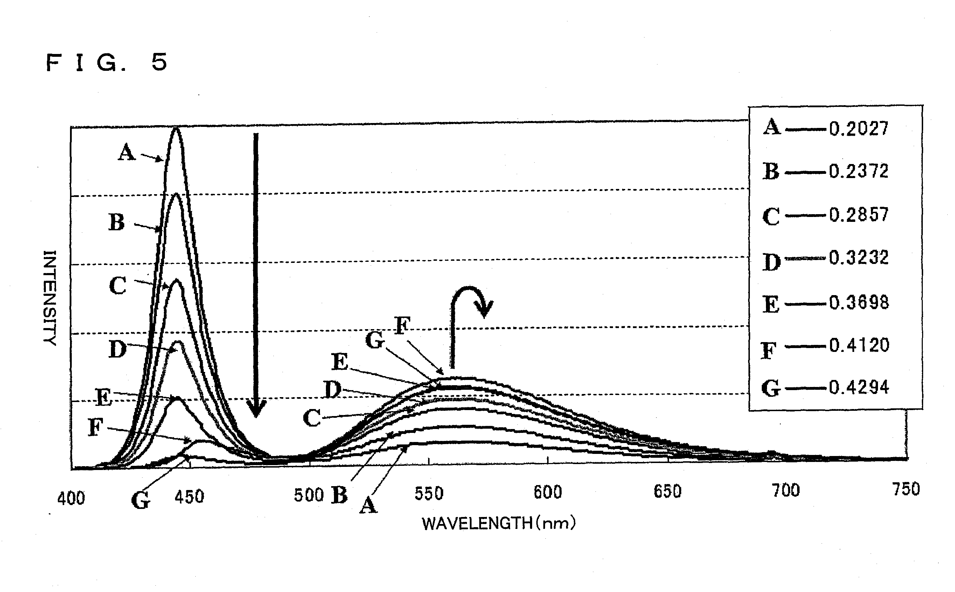

FIG. 5 is a graph illustrating the change in a spectral distribution of the light emitted from the light emitting section 16 (i.e., the composite light of the light from the blue LED 12 and the light from the yellow phosphor 13). A plurality of spectral distributions illustrated in the graph correspond to spectral distributions of typical samples selected from samples illustrated in FIG. 4 and are respectively designated by values of the color coordinate x (on the x-axis) in the chromaticity diagram of FIG. 4. Accordingly, as the value of the color coordinate x is larger, the composite light is moved from the blue region to the yellow region in the chromaticity diagram. Also, out of two peak wavelengths of each distribution illustrated in the graph, a peak at approximately 440 nm corresponds to the wavelength of the blue light emitted from the blue LED 12 and a peak at approximately 570 nm corresponds to the wavelength of the yellow light emitted from the yellow phosphor 13.

It is understood from the graph of FIG. 5 that as the value of the color coordinate x is increased (namely, as the amount of yellow phosphor is increased), the intensity of the light of the blue light wavelength (of approximately 440 nm) is reduced and that the intensity of the blue light is the minimum when the amount of yellow phosphor is the maximum (namely, the color coordinate x has a value of 0.4294). This is because the probability of the collision of the light emitted from the blue LED 12 against the yellow phosphor 13 is increased and the quantity of blue light passing through the encapsulating resin layer 15 is reduced as the amount of yellow phosphor is increased as described above. Furthermore, it is understood from the graph that when the color coordinate x has a value larger than approximately 0.4, the intensity of the blue light is sufficiently suppressed by the yellow phosphor 13 working as the inhibitor particularly to an extent that a photosensitive resin sensitive to the g-line (of a wavelength of 436 nm) does not react.

Furthermore, as the amount of yellow phosphor is increased, the intensity of the light of the yellow light wavelength (of approximately 570 nm) is increased, and the intensity is the maximum in a sample with the color coordinate x having a value of 0.4120. On the other hand, in a sample with the color coordinate x having a value of 0.4294 including the maximum amount of yellow phosphor, the intensity of the yellow light is lower than in the sample with the color coordinate x having a value of 0.4120. This is because when the amount of yellow phosphor 13 included in the encapsulating resin layer 15 exceeds a prescribed amount, the yellow light emitted from the yellow phosphor 13 when excited by the blue light of the blue LED 12 is more highly probably blocked by another yellow phosphor 13 disposed closer to the outside of the encapsulating resin layer 15.

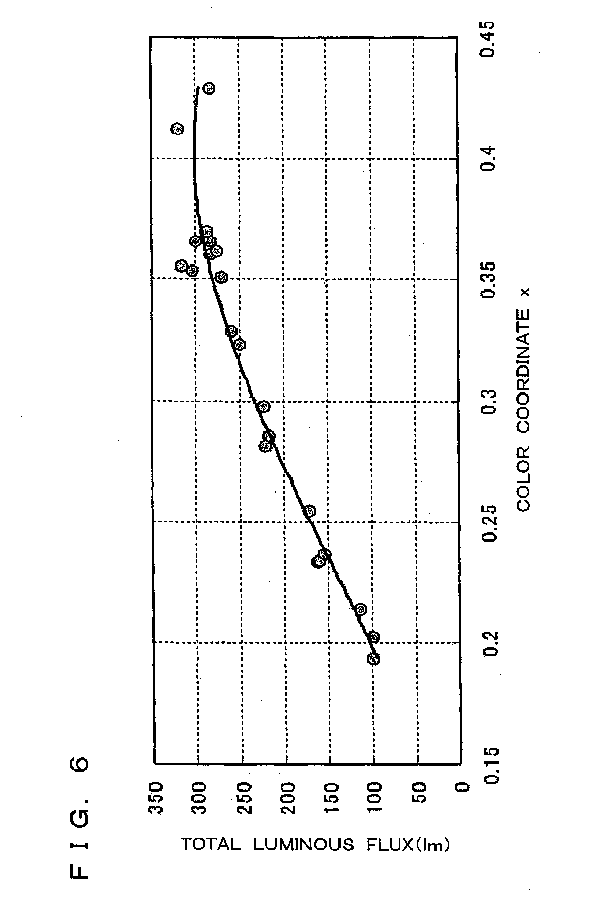

FIG. 6 is a graph illustrating the change in the total luminous flux of the light emitted from the light emitting section 16 obtained by changing the amount of yellow phosphor 13 included in the encapsulating resin layer 15. The total luminous flux means the quantity of entire light emitted from the light emitting section 16 and corresponds to the total quantity of the composite light of the light emitted from the plural blue LEDs 12 and the light emitted from the yellow phosphor 13. In the graph of FIG. 6, the abscissa indicates the color coordinate x and the ordinate indicates the total luminous flux (lm: lumen). As the value of the color coordinate x of the abscissa is increased, the amount of yellow phosphor 13 included in the encapsulating resin layer 15 is increased. Also, respective sample points indicated in the graph correspond to the samples respectively including different amounts of yellow phosphor illustrated in FIG. 4 (indicated by the symbol ◇).

It is understood from the graph of FIG. 6 that as the value of the color coordinate x is increased (namely, as the amount of yellow phosphor is increased), the total luminous flux tends to be increased, but the total luminous flux is the maximum not in the sample with the color coordinate x having the maximum value of 0.4294 (namely, including the maximum amount of yellow phosphor) but in the sample with the color coordinate x having a value of 0.4120. This is because when the amount of yellow phosphor 13 included in the encapsulating resin layer 15 exceeds a prescribed amount, the yellow light emitted from the yellow phosphor 13 through excitement by the blue light of the blue LED 12 is more highly probably blocked by another yellow phosphor 13 included in the encapsulating resin layer 15.

Accordingly, there is a suitable amount of phosphor for maximizing the total luminous flux of the light emitted from the light emitting section 16, and it is preferred, on the basis of the experimental results, that the yellow phosphor 13 is included in the encapsulating resin layer 15 so as to attain a value of the color coordinate x of approximately 0.4. The value of the total luminous flux is sufficiently large when the color coordinate x has a value of 0.35 through 0.45, and therefore, it is preferred to adjust the amount of yellow phosphor 13 included in the encapsulating resin layer 15 so as to attain a value of the color coordinate x of 0.35 through 0.45.

On the basis of the aforementioned experimental results, when the amount of yellow phosphor 13 included in the encapsulating resin layer 15 is adjusted so as to attain a value of the color coordinate x of the light emitted from the light emitting section 16 of approximately 0.4, an illuminating apparatus capable of preventing a photosensitive resin sensitive to a specific wavelength (of, for example, the g-line) from reacting and capable of emitting light with large total luminous flux is attained. Furthermore, on the basis of the chromaticity diagram of FIG. 4, when the value of the color coordinate x is adjusted to approximately 0.4, the color coordinate y has a value approximate to 0.5, and in this case, bright yellow (lemon yellow) light different from dark yellow light of a yellow fluorescent light conventionally used in a clean room can be emitted.

Accordingly, a room such as a clean room where the illuminating apparatus is installed can be kept bright, resulting in attaining effects that the safety of an operator is secured and an operator is not put under stress. It is noted that these effects can be attained when the value of the color coordinate x is approximately 0.4 through 0.45.

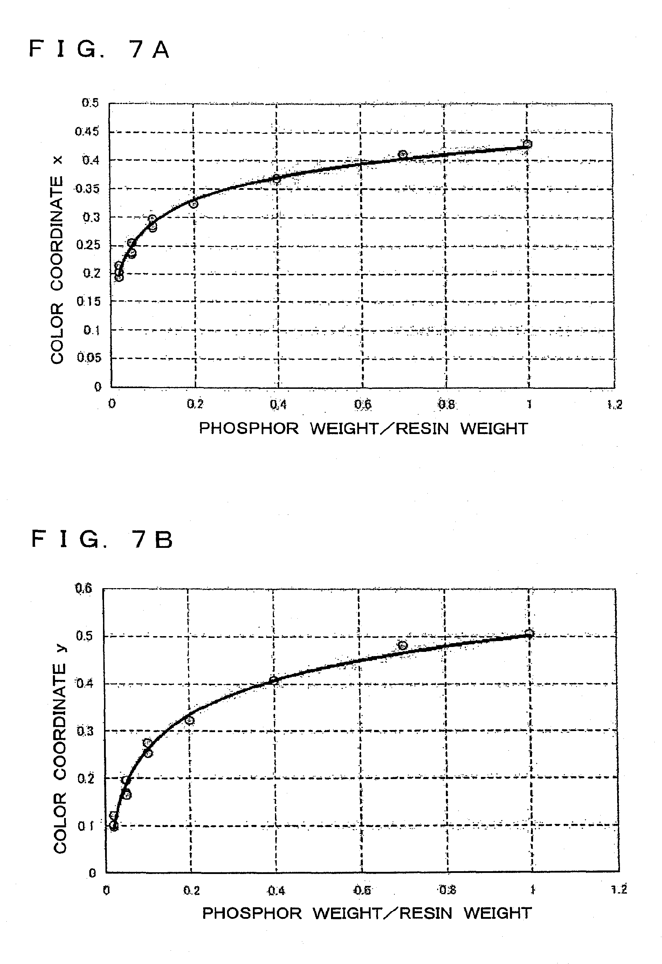

FIGS. 7A and 7B are graphs illustrating the relationships between a weight ratio between the encapsulating resin 14 and the yellow phosphor 13 included in the encapsulating resin layer 15 and color coordinates of light emitted from the light emitting section 16. As illustrated in the graphs, as a value of the weight ratio of the yellow phosphor/encapsulating resin is increased (namely, as the amount of yellow phosphor included in the encapsulating resin layer is increased), the values of the color coordinate x and the color coordinate y are increased. Accordingly, there is correlation between the amount of yellow phosphor included in the encapsulating resin layer and the color coordinates of the emitted light, and hence, the values of the color coordinate x and the color coordinate y can be adjusted by controlling the weight ratio of the yellow phosphor/encapsulating resin.

In order to attain an illuminating apparatus capable of, for example, preventing a photosensitive resin sensitive to a specific wavelength (of, for example, the g-line) from reacting and capable of emitting light with large total luminous flux, the weight ratio of the yellow phosphor/encapsulating resin can be adjusted to 0.6 for adjusting the color coordinate x of the light emitted from the light emitting section 16 to an optimum value of approximately 0.4.

A photosensitive resin such as a photoresist used in the fabrication processing of a semiconductor integrated circuit or the like is changed in its physical property such as alkali-solubility or a curing property through a reaction to, for example, a wavelength of the i-line (of a wavelength of 365 nm) in the UV region or a wavelength of the g-line (of a wavelength of 436 nm) in the blue region. Since the illuminating apparatus 10 of this embodiment uses the blue LED 12 as a light source, a wavelength in the UV region generated by a mercury lamp or the like is not generated, and it is possible to suppress a wavelength in the blue region for preventing a photosensitive resin from reacting by using the yellow phosphor 13 as a phosphor included in the encapsulating resin layer 15.

Although the yellow phosphor 13 is exemplarily used as the phosphor included in the encapsulating resin layer 15, the phosphor included in the encapsulating resin layer for suppressing the light emitted from the blue LED 12 is not limited to the yellow phosphor, but similar effects can be attained by using a red phosphor or a green phosphor that emits light not including a wavelength component in the blue region. In particular, when a red phosphor is mixedly and appropriately used in addition to the yellow phosphor in the encapsulating resin layer, light with higher color rendering can be emitted while suppressing the light of a wavelength in the blue region. As the red phosphor for emitting red light when excited by a blue phosphor, Sr₂Si₅N₈: Eu or CaAlSiN₃: Eu2+ may be suitably used.

Moreover, a green phosphor may be additionally included in the encapsulating resin. Thus, further multicolor light may be emitted while suppressing the light of a wavelength in the blue region. As the green phosphor for emitting green light when excited by a blue phosphor, α-SiAlON: Ce3+, β-SiAlON: Eu2+, Sr aluminate (SrAl₂O₄: Eu2+), (Sr, Ba)₂SiO₄: Eu2+, or Ca₃(Sc, Mg)₂Si₃O₁₂: Ce3+ is suitably used.

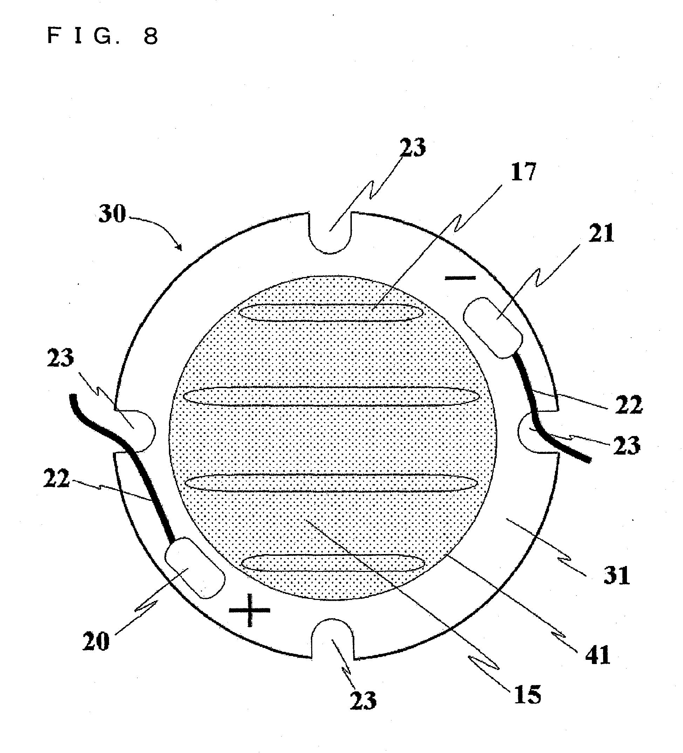

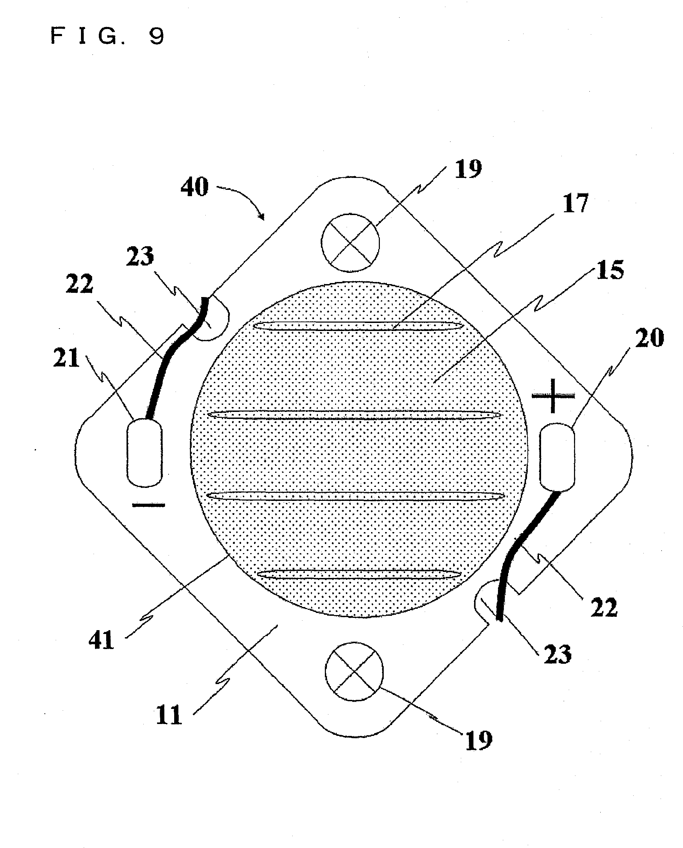

FIGS. 8 and 9 are plan views of light emitting devices 30 and 40 described as modifications of Embodiment 1. Like reference numerals are used to refer to like elements used in the light emitting device 10 of FIG. 1, and the detailed description is omitted.

Although the outline of the light emitting device 10 (or the substrate 11) is described as a substantially square rectangular shape in Embodiment 1, the light emitting device 30 (or a substrate 31) may be in a circular shape as illustrated in FIG. 8, and the shape of the light emitting section is not limited to that illustrated in FIG. 1 but a light emitting section 41 in a circular or an elliptic shape as illustrated in FIG. 8 or 9 may be used.

### (EMBODIMENT 2)

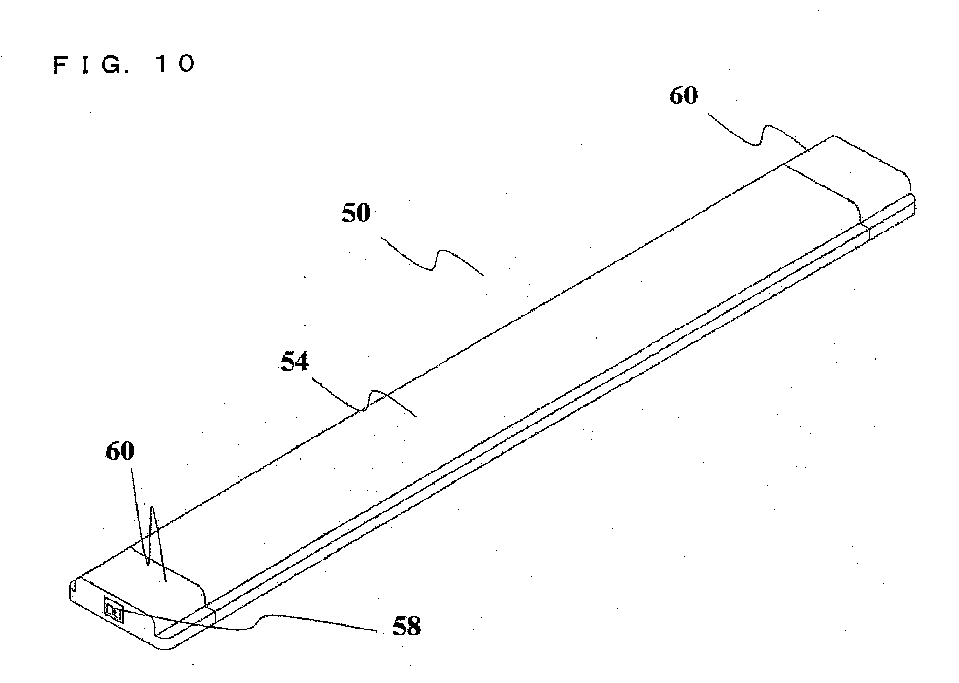

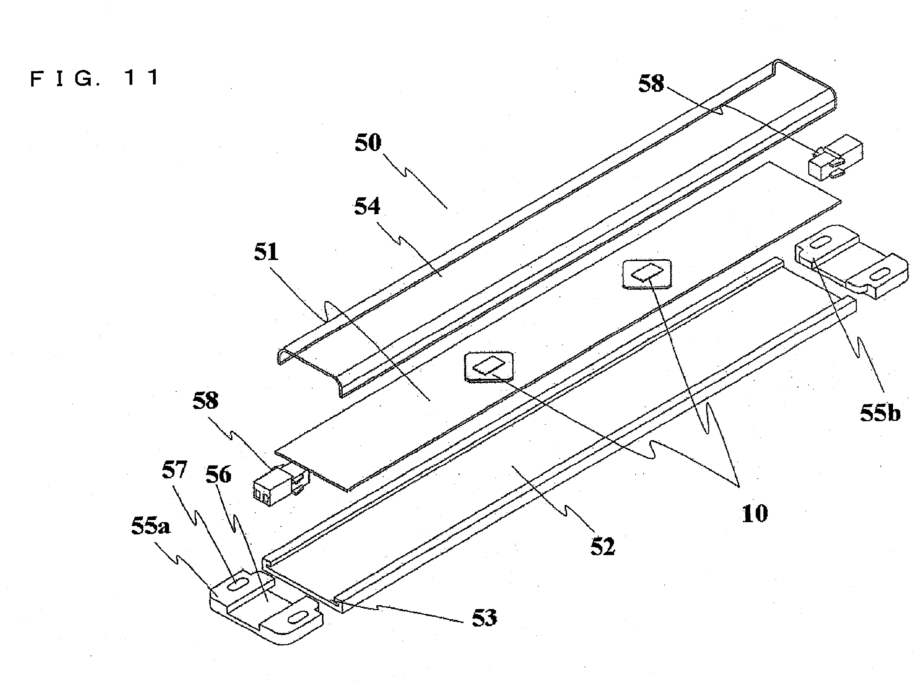

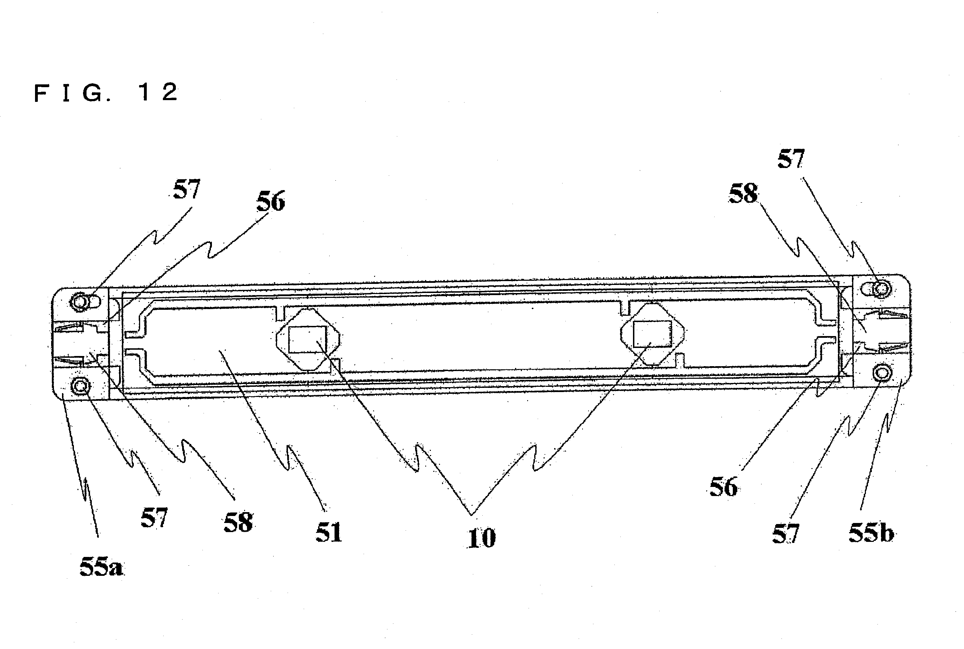

Next, an LED illuminating apparatus using the light emitting device of Embodiment 1 will be described in Embodiment 2 of the invention. FIG. 10 is an assembling perspective view of the LED illuminating apparatus 50 of Embodiment 2. FIG. 11 is an exploded perspective view of the LED illuminating apparatus 50 of Embodiment 2. FIG. 12 is a schematic plan view of a substrate 51 included in the LED illuminating apparatus 50 of Embodiment 2 on which a light emitting device 10 is mounted.

Referring to FIGS. 10 through 12, the LED illuminating apparatus 50 includes two light emitting devices 10, and the light emitting devices 10 are arranged to be mounted on the substrate 51. The substrate 51 is, for example, a glass epoxy substrate, and the surface of the substrate 51 may be provided with white coating or provided with a reflection sheet (not shown) so that the light emitting devices 10 can emit light to the outside as much as possible.

The substrate 51 is fit in engaging grooves 53 of a base 52 made of a metal such as aluminum, and the base 52 also functions as a radiator plate for releasing heat transferred from the light emitting devices 10 through the substrate 51. Also, on a side of the substrate 51 on which the light emitting devices 10 emits light, a cover 54 working as a diffusing member for diffusing the light emitted from the light emitting devices 10 is provided. The cover 54 is made of, for example, a semitranslucent resin such as polycarbonate. It exhibits an effect to overcome a problem of glare, which arises in using a light source with directivity such as an LED in an illuminating apparatus.

At both ends of the base 52, holding members 55a and 55b fit in the engaging grooves 53 for fixing the substrate 51 are provided. Each of the holding members 55a and 55b has a groove 56 and apparatus attaching holes 57. A connector 58 for supplying a direct current to the light emitting device 10 and connecting it to a power supply (not shown) or another illuminating apparatus is provided in the groove 56. A power line for supplying a current and a lead wire (not shown) corresponding to a control line for controlling the light emitting device are connected within the connector 58. Furthermore, attaching members (not shown) such as screws are inserted through the apparatus attaching holes 57, so as to fix the LED illuminating apparatus 50 on a ceiling surface or a wall surface. Moreover, exterior members 60 fix the holding members 55a and 55b and the cover 54, and thus, the LED illuminating apparatus 50 is constructed.

### (EMBODIMENT 3)

While each of Embodiments 1 and 2 describes the light emitting device in the form of a module in which a plurality of LEDs formed on a substrate are covered with an encapsulating resin layer including a phosphor, an LED illuminating apparatus 70 of Embodiment 3 is an LED illuminating apparatus including a light emitting device, that is, an LED individually covered, on a substrate, by an encapsulating resin layer including a phosphor (namely, an LED generally designated as a surface mount LED).

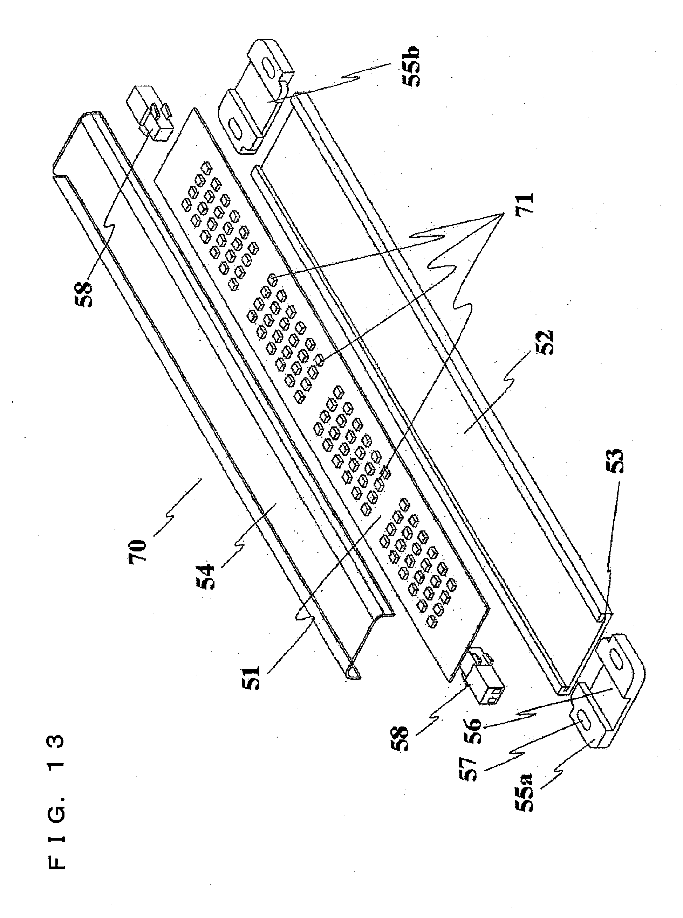

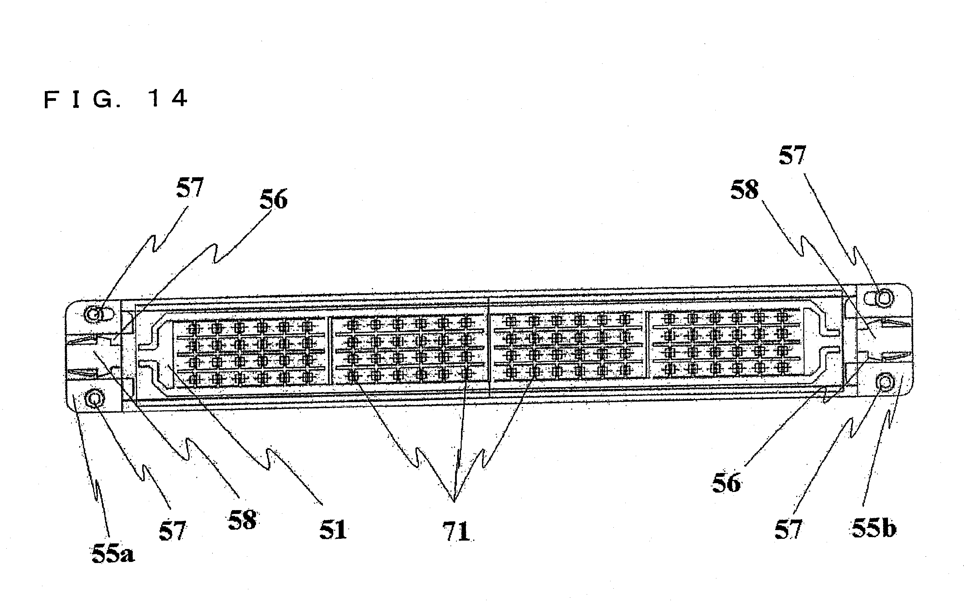

FIG. 13 is an exploded perspective view of the LED illuminating apparatus 70 of Embodiment 3. FIG. 14 is a plan view of a substrate of the LED illuminating apparatus of Embodiment 3. Like reference numerals are used to refer to like elements used in the LED illuminating apparatus of Embodiment 2 and the detailed description is omitted. As illustrated in FIG. 13, a plurality of light emitting devices 71 each of an LED package are mounted on a substrate 51 in four rows. Each light emitting device 71 is obtained by covering and encapsulating one blue LED with an encapsulating resin including a yellow phosphor working as an inhibitor. Similarly to the light emitting device described in Embodiment 1, a blue LED obtained by forming a gallium nitride-based compound semiconductor on a sapphire substrate is used and encapsulated by epoxy resin including a yellow phosphor of BOS phosphor, (BaSr)₂SiO₄: Eu2+. It goes without saying that other materials described in Embodiment 1 may be used for the blue LED, the yellow phosphor and the encapsulating resin.

In order to suppress a wavelength in the UV region such as the i-line (of a wavelength of 365 nm) or a wavelength in the blue region such as the g-line (of a w-avelength of 436 nm) for preventing a photosensitive resin such as a photoresist from reacting, composite light, emitted from each light emitting device 71, of blue light emitted from the blue LEDs and yellow light emitted from the yellow phosphor is adjusted to have values of the color coordinate x and the color coordinate y similar to those of the light emitting device of Embodiment 1.

In addition to the yellow phosphor, the encapsulating resin may further include, as the inhibitor for a specific wavelength, a red phosphor or a green phosphor that emits light including no wavelength component in the blue region because thus the color rendering of the composite light is increased. As the red phosphor or the green phosphor, any of the materials described in Embodiment 1 may be used. Accordingly, since the light emitting device 71 of this embodiment also uses an LED as a light source, a wavelength in the UV region generated by a mercury lamp or the like is not generated, and it is possible to prevent a photosensitive resin from reacting to a wavelength in the blue region by using the yellow phosphor as a phosphor included in the encapsulating resin layer.

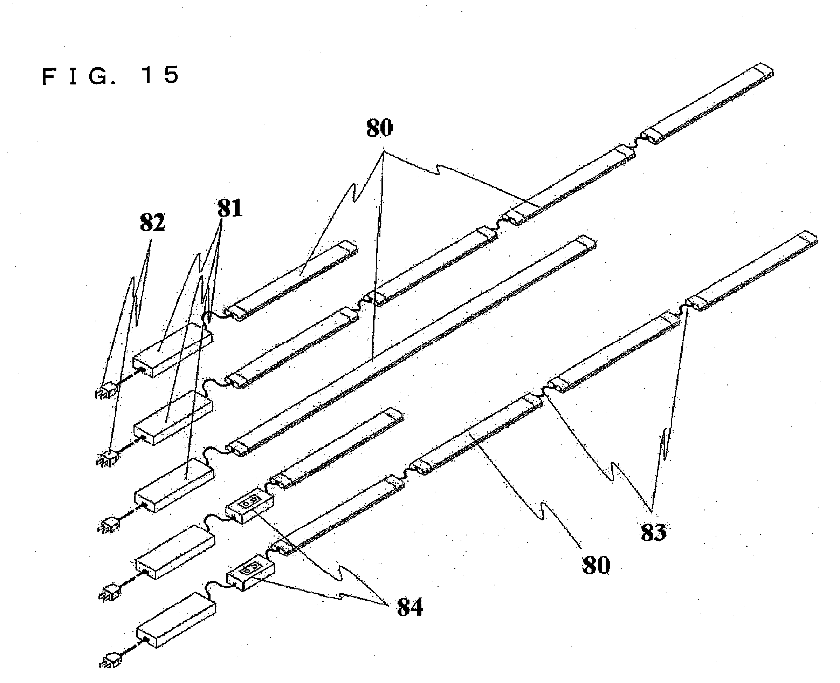

FIG. 15 is a perspective view of LED lighting equipment obtained by connecting an LED illuminating apparatus 80 according to Embodiment 2 or 3 to a power supply unit 81 or another LED illuminating apparatus 80. The LED illuminating apparatus 80 is connected, through a connecting wire 83, to the power supply unit 81 that converts a commercial power and supplies a converted power to a light emitting device (not shown) included in the LED illuminating apparatus 80 and a plug socket 82 connected to the commercial power. A plurality of LED illuminating apparatuses 80 may be connected to one another, or the LED illuminating apparatus 80 may be in a longer shape depending upon the number of light emitting devices included therein. Alternatively, the LED lighting equipment may be turned ON/OFF by using a switching unit 84.

### (EMBODIMENT 4)

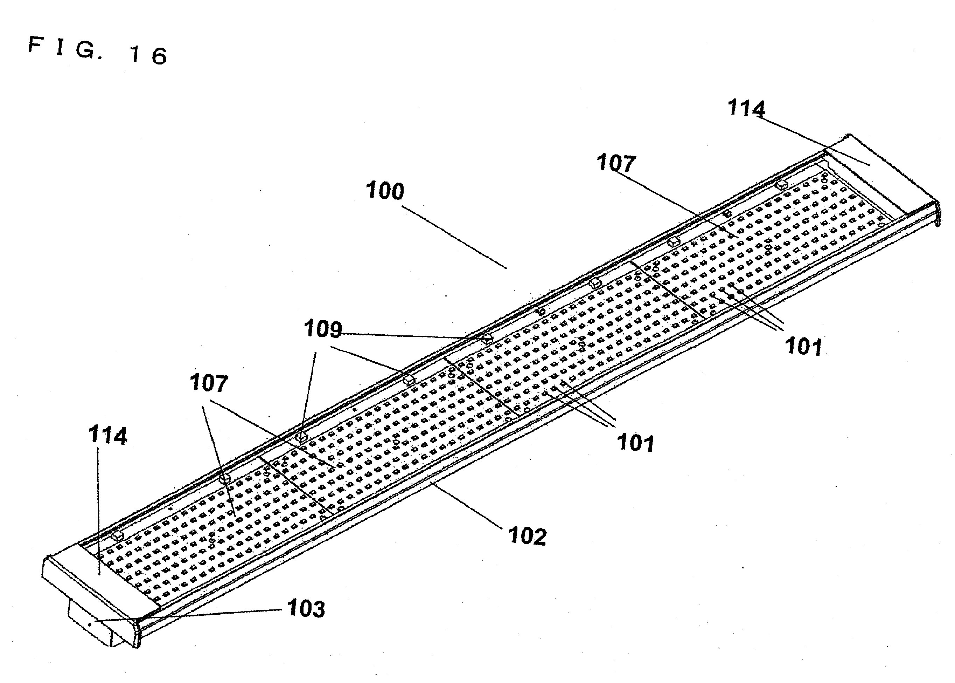

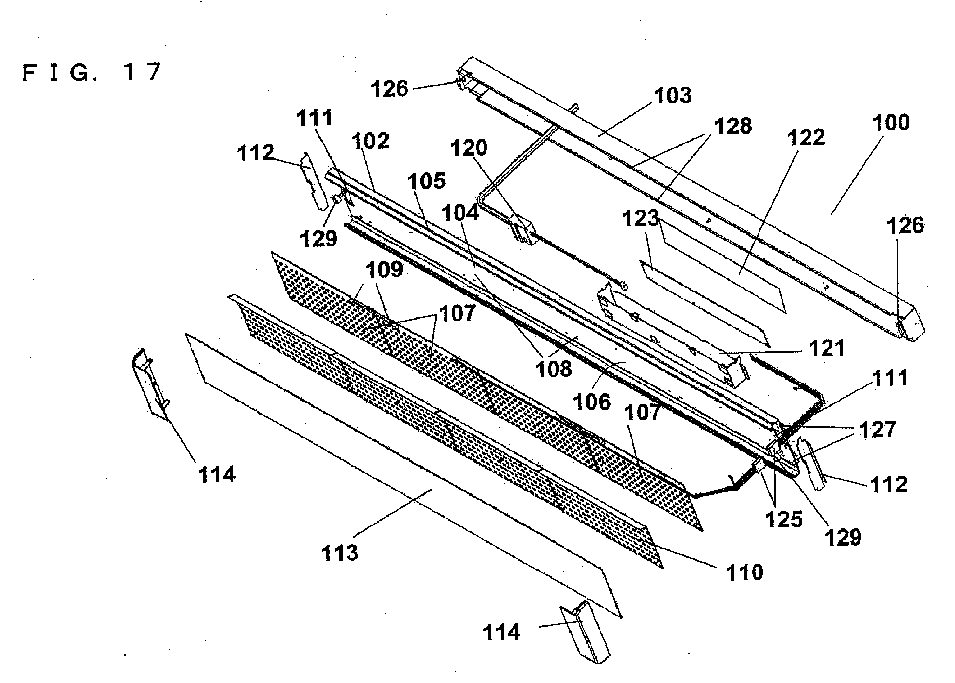

FIG. 16 is an assembling perspective view of a principal part of an LED illuminating apparatus according to Embodiment 4 of the invention. FIG. 17 is an exploded perspective view of the principal part of the LED illuminating apparatus of FIG. 16. The LED illuminating apparatus of Embodiment 4 is an illuminating apparatus similar to the LED illuminating apparatus of Embodiment 2 or 3 that includes a light emitting section for emitting light in which the quantity of light of a blue wavelength region is reduced by increasing the amount of yellow phosphor included in an encapsulating resin, and as another characteristic, it further includes a cut filter for cutting light of a blue wavelength region included in the light emitted from the light emitting section.

The LED illuminating apparatus 100 is an illuminating apparatus in a long narrow shape, and separately includes a case 102 for housing LEDs 101 corresponding to a light source and working as a light emitting section (hereinafter referred to as the "light case 102") and a case 103 for housing a power supply circuit for supplying a current to the LEDs 101 (hereinafter referred to as the "power case 103"), and the light case 102 and the power case 103 are provided removably from each other.

The LED illuminating apparatus 100 is attached with bolts with a face of the power case 103 not opposing the light case 102 faced to a ceiling surface, and the power supply circuit housed in the power case 103 is connected to a power line extended in a ceiling space from an external power source. Furthermore, when the light case 102 and the power case 103 are fit to each other and the LEDs 101 housed in the light case 102 and the power supply circuit housed in the power case are connected through wires, an AC voltage supplied from the external power source is converted into a DC voltage and rectified by the power supply circuit to be supplied to the LEDs 101. In this manner, the LED illuminating apparatus 100 can perform illumination by making the LEDs 101 emit light.

Next, the light case 102 and components such as the LEDs housed in the light case 102 will be described. The light case 102 is made of a metal with a small weight and good heat radiation, such as aluminum, and is in the shape of a substantially long narrow rectangular parallelepiped including a bottom face 104 and side faces 105 each having a partly bent portion and having a recess, that is, a groove extending in the lengthwise direction with a forked end. Also, the light case 102 has openings at both ends in the widthwise direction and a side opposing the bottom face. Moreover, a plurality of (specifically four in this embodiment) LED substrates 107 on each of which a plurality of LEDs 101 are mounted are attached on the bottom face 104 of the light case 102 with screws through LED substrate attaching holes 108 of the bottom face 104.

Incidentally, each LED substrate 107 is a printed wiring board, on which a plurality of LEDs 101 are arranged at equal intervals in a matrix. Also, the LED substrate 107 is provided with wiring patterns (not shown) for conductively connecting the plural LEDs 101, a limiting resistor (not shown) for allowing a constant current to pass through the LEDs 101, and LED substrate connectors 109 for connecting the plural LED substrates 107 to one another. It is noted that each LED substrate 107 has two LED substrate connectors 109, both of which are provided at the end on a first side of the LED substrate 107. Accordingly, when the plural LED substrates 107 are attached onto the bottom face 104 with their first sides having the LED substrate connectors 109 aligned, the LED substrate connectors 109 and wires used for connecting the LED substrate connectors 109 can be housed in a space formed by the bent portion of the side faces 105. Therefore, when the LED illuminating apparatus 100 is seen from the illuminated side, the LED substrate connectors 109 and the wires are not visible from the outside, which is preferred also from the viewpoint of the appearance.

Furthermore, a reflection sheet 110 is provided on the face of the LED substrate 107 on which the LEDs 101 are mounted. Therefore, light emitted from the LEDs 101 can be prevented from being absorbed by the LED substrates 107, and hence, the quantity of light emitted from the LED illuminating apparatus 100 can be prevented from reducing. It is noted that, for example, a polyethylene terephthalate film is used as the reflection sheet 110. Furthermore, power case attaching holes 111 each in a rectangular shape for fixing the power case 103 and the light case 102 are provided at the both ends on the shorter sides of the bottom face 104. Also, side covers 112 for covering the openings at the ends are provided at the both ends in the widthwise direction of the bottom face 104. Each side cover 112 is made of a white resin with a high reflecting property, and hence, light leakage through the openings at the ends can be prevented.

Next, the LEDs 101 working as the light emitting section will be described. Each LED 101 is a surface mount LED including a blue LED and a yellow phosphor, and the blue LED is encapsulated with the encapsulating resin including the yellow phosphor. Also, as described above, the quantity of light emitted from the blue LED and passing through the encapsulating resin can be reduced by increasing the amount of yellow phosphor included in the encapsulating resin, and therefore, the LED 101 can emit bright yellow (lemon yellow) light in which the quantity of light of a wavelength in the UV region such as the i-line (of a wavelength of 365 nm) or a wavelength in the blue region such as the g-line (of a wavelength of 436 nm) is reduced.

Furthermore, as described above, when the amount of yellow phosphor included in the encapsulating resin is adjusted so as to make the color coordinate x of the light emitted from the LED 101 have a value of approximately 0.4, a photosensitive resin sensitive to a specific wavelength (of, for example, the g-line) can be prevented from reacting and light with large total luminous flux can be emitted.

Moreover, a filter diffuser panel 113 that covers the LEDs 101 and works as blocking means including a cut filter for blocking a wavelength in the UV region such as the i-line (of a wavelength of 365 nm) or a specific wavelength in the blue region such as the g-line (of a wavelength of 436 nm) and a diffuser panel is fit in recesses 106 formed at the tips of the side faces 105 of the light case 102. It is noted that the cut filter is made of, for example, polyethylene terephthalate (with a refractive index of 1.52) and that the diffuser panel is made of polycarbonate (with a refractive index of 1.59), an acrylic sheet (with a refractive index of 1.49), glass or the like.

Accordingly, the quantity of light of the blue wavelength region included in the light emitted from the LEDs 101 can be reduced by increasing the amount of yellow phosphor included in the encapsulating resin as well as the light of the blue wavelength region can be further blocked by the filter diffuser panel 113 in the LED illuminating apparatus 100, and therefore, the light of the blue wavelength region included in the light emitted from the LED illuminating apparatus 100 can be more definitely reduced. Furthermore, at the both ends in the widthwise direction of the light case 102, holding members 114 for holding the components such as the filter diffuser panel 113 by pressing them from the illuminated direction are provided.

Next, the power case 103 and components such as a power circuit unit housed in the power case 103 will be described. The power case 103 is a rectangular parallelepiped housing made of a metal such as iron, and includes therein a coupling terminal 120 working as a connection terminal to be connected to the power circuit unit and the power line from the external power source. Furthermore, the power circuit unit is housed within a metallic power circuit box 121 for securing the safety of the illuminating apparatus. The power circuit unit includes electronic components (not shown) such as a capacitor and a transformer mounted on a power circuit substrate 122 and is attached in the power circuit box 120 with an insulating sheet 123 sandwiched therebetween. It is noted that the power circuit unit may be molded with a resin such as silicon for further securing the insulation between the power circuit unit and the power circuit box 120.

The length of the power case 103 in the lengthwise direction is substantially the same as the length of the light case 102 in the lengthwise direction, and the length of the power case 103 in the widthwise direction is substantially a half of the length of the light case 102 in the widthwise direction. Accordingly, when the power case 103 is attached in the center in the widthwise direction on the back side of the bottom face 104 of the light case 102, a part of the back side of the light case 102 is exposed outside due to the difference in the length of the shorter sides between the power case 103 and the light case 102. Therefore, the light case 102 made of a metal with high heat radiation such as aluminum can be effectively used for efficiently releasing heat generated from the LEDs 101.

Moreover, the power circuit unit and the LED substrate 107 have a connector 125 for mutual connection, and the connector 125 is inserted through the power case attaching hole 111 of the light case 102 for the connection.

Although not shown in the drawings, an incoming hole for drawing the power line extending on the ceiling is provided on the face opposing the ceiling of the power case 103, and a plastic buffer ring is disposed around the incoming hole. Therefore, burr formed around the incoming hole during the fabrication of the illuminating apparatus can be covered, and hence, the power line can be prevented from being damaged by the burr formed around the incoming hole in drawing the power line through the incoming hole. It is noted that the damage of the power line can be prevented by performing end processing such as flange processing on the incoming hole instead of providing the buffer ring.

Furthermore, for fixing the light case 102 and the power case 103, hooks 126 provided at the both ends in the widthwise direction of the power case 103 are engaged with the power case attaching holes 111 of the light case 102, and engagement projections 128 provided along the longer sides of the power case 103 are fit in engagement catches 127 having an L-shaped cross-section formed along the longer sides on the back face of the light case 102, and thus, the light case 102 and the power case 103 are firmly fixed to each other. Furthermore, the hooks 126 are fixed with screws 129.

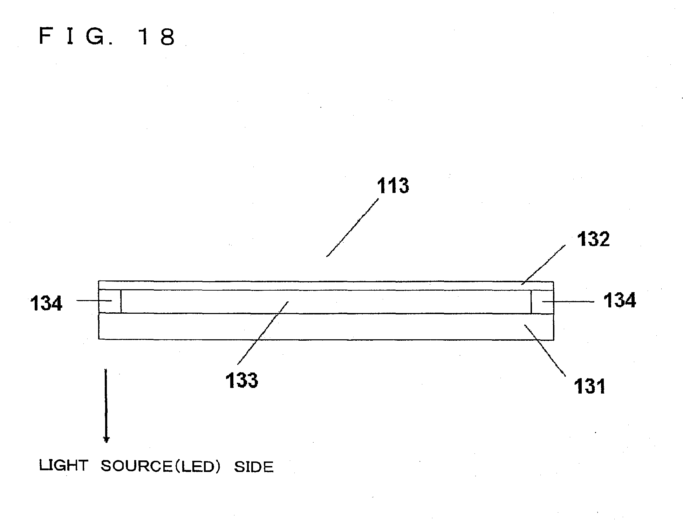

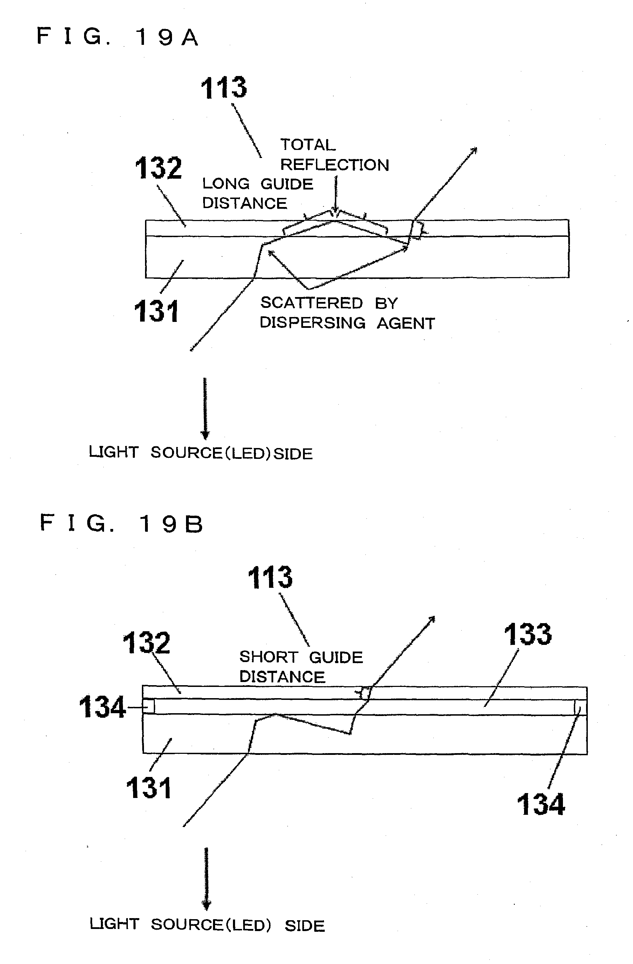

Next, the structure of the filter diffuser panel 113 will be described in more detail. FIG. 18 is a cross-sectional view of the filter diffuser panel 113. FIGS. 19A and 19B are diagrams explaining an optical path of light passing through the filter diffuser panel.

As illustrated in FIG. 18, a diffuser panel 131 and a cut filter 132 are adhered to each other with an air gap 133 sandwiched therebetween by an adhesive member 134 provided in a peripheral portion of the diffuser panel 131. An adhesive tape or an adhesive is used as the adhesive member 134, and it preferably has a given thickness for forming the air gap 133 between the diffuser panel 131 and the cut filter 132. It is noted that the adhesive member 134 may be provided over the entire periphery of the diffuser panel 131 or may be provided in merely a part of the periphery of the diffuser panel 131 for adhering the diffuser panel 131 and the cut filter 132 with the air gap 133 formed therebetween.

Accordingly, the light of the blue wavelength region included in the light emitted from the LED illuminating apparatus 100 can be definitely reduced as described above. Also, since the diffuser panel 131 and the cut filter 132 are provided without closely adhering to each other but with the air gap 133 formed therebetween, the quantity of light absorbed in the cut filter 132 of the filter diffuser panel 113 can be reduced.

Next, the reason why the quantity of light absorbed in the cut filter 132 of the filter diffuser panel 113 can be reduced by forming the air gap 133 between the diffuser panel 131 and the cut filter 132 will be described. FIG. 19A illustrates an optical path of light passing through the filter diffuser panel 113 when the cut filter 132 and the diffuser panel 131 are closely adhered to each other, and FIG. 19B illustrates an optical path of light passing through the filter diffuser panel 113 when the air gap 133 is formed between the cut filter 132 and the diffuser panel 131.

Referring to FIG. 19A, in the filter diffuser panel 113 in which the cut filter 132 and the diffuser panel 131 are closely adhered to each other, light emitted from a light source is scattered by a dispersing agent included in the diffuser panel 131. A part of the scattered light is guided to proceed within the cut filter 132 as illustrated with a solid line in the drawing, and when it reaches the surface of the cut filter 132 at an incident angle exceeding a predetermined incident angle, it is totally reflected on the surface of the cut filter 132. Then, the totally reflected light is guided to proceed within the cut filter 132 again, scattered by the dispersing agent included in the diffuser panel 132 again, and proceeds in an outgoing direction. Thereafter, it passes through the cut filter 132 again and outgoes.

Referring to FIG. 19B, in the filter diffuser panel 113 in which the air gap 133 is provided between the cut filter 132 and the diffuser panel 131, light emitted from a light source is scattered by a dispersing agent included in the diffuser panel 131. A part of the scattered light is totally reflected on the surface of the diffuser panel 131 when it reaches the surface of the diffuser panel 131 at the same incident angle as that of the light illustrated in FIG. 19A. Then, the totally reflected light is scattered again by the dispersing agent included in the diffuser panel 131 and is changed in the proceeding direction to the outgoing direction, and when it reaches the surface of the diffuser panel 131 again at an incident angle smaller than the predetermined incident angle, it is refracted on the surface of the diffuser panel 131, passes through the cut filter 132 and outgoes. In this case, differently from the light illustrated in FIG. 19A, the light with an incident angle exceeding the predetermined incident angle is first totally reflected on the surface of the diffuser panel 131, and hence, most of light passing through the cut filter 132 and reaching the surface of the cut filter 132 reaches at an incident angle exceeding the predetermined incident angle. Therefore, it is not totally reflected on the surface of the cut filter 132 but is allowed to outgo.

Accordingly, as illustrated in FIGS. 19A and 19B, a guide distance in the cut filter 132 in the filter diffuser panel 113 including the cut filter 132 and the diffuser panel 131 closely adhered is longer than a guide distance in the cut filter 132 in the filter diffuser panel 113 including the air gap 133 formed between the cut filter 132 and the diffuser panel 131.

Furthermore, in addition to the light having a specific wavelength component, light of another wavelength is also slightly absorbed in the cut filter 132, and hence, an optical loss derived from the absorption in the cut filter 132 is smaller when the guide distance in the cut filter 132 is smaller. Therefore, in the filter diffuser panel 133 in which the air gap 133 is formed between the cut filter 132 and the diffuser panel 131, reduction in the quantity of light can be reduced as compared with that in the filter diffuser panel 113 including the cut filter 132 and the diffuser panel 131 closely adhered.

Moreover, since the life of the cut filter 132 is reduced due to the light absorption in the cut filter 132, the filter diffuser panel 113 in which the air gap 133 is formed between the cut filter 132 and the diffuser panel 131 has a longer life than the filter diffuser panel 113 in which the cut filter 132 and the diffuser panel 131 are closely adhered.

Incidentally, although the filter diffuser panel 113 of this embodiment has the structure in which the air gap 133 is provided between the cut filter 132 and the diffuser panel 131, not only the air gap 133 but also a buffer member with a smaller refractive index than the cut filter 132 and the diffuser panel 131 may be provided instead therebetween. Alternatively, such a buffer member may also work as the adhesive member.

Although the diffuser panel 131 opposes the light source in the filter diffuser panel 113 of this embodiment, similar effects can be attained even when the cut filter 132 opposes the light source.

In this manner, the wavelength in the UV region such as the i-line (of a wavelength of 365 nm) or the wavelength in the blue region such as the g-line (of a wavelength of 436 nm) is suppressed, so as to prevent a photosensitive resin such as a photoresist from reacting, by combining a blue LED and a yellow phosphor, a red phosphor and a green phosphor emitting light when excited by the blue LED and by using the phosphor as an inhibitor in the illuminating apparatus described in this embodiment, and the LED is not limited to the blue LED. The present embodiment is applicable to an LED of another color as far as the wavelength in the UV region such as the i-line (of a wavelength of 365 nm) or the wavelength in the blue region such as the g-line (of a wavelength of 436 nm) can be suppressed by appropriately combining the LED with another type of phosphor. Furthermore, although the phosphor is included in the encapsulating resin in the aforementioned embodiment, the phosphor may be provided by being applied to the surface of the encapsulating resin.

### (EMBODIMENT 5)

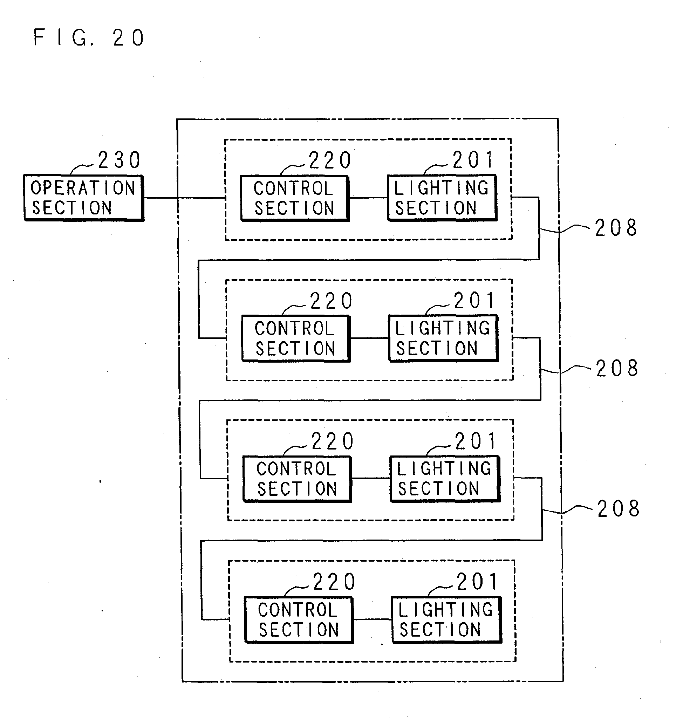

FIG. 20 is a block diagram illustrating the structure of lighting equipment including a plurality of illuminating apparatuses according to Embodiment 5. In this drawing, the lighting equipment of Embodiment 5 is surrounded with an alternate long and two short dashes line, and each illuminating apparatus is surrounded with a broken line. The lighting equipment of Embodiment 5 includes a plurality of illuminating apparatuses electrically connected to one another through connecting members 208. Furthermore, the lighting equipment is connected to an external operation section 230. Each illuminating apparatus of Embodiment 5 includes a lighting section 201 and a control section 220 for controlling on/off of the lighting section 201. The control section 220 controls the on/off of the lighting section 201 in accordance with an instruction signal supplied from the operation section 230.

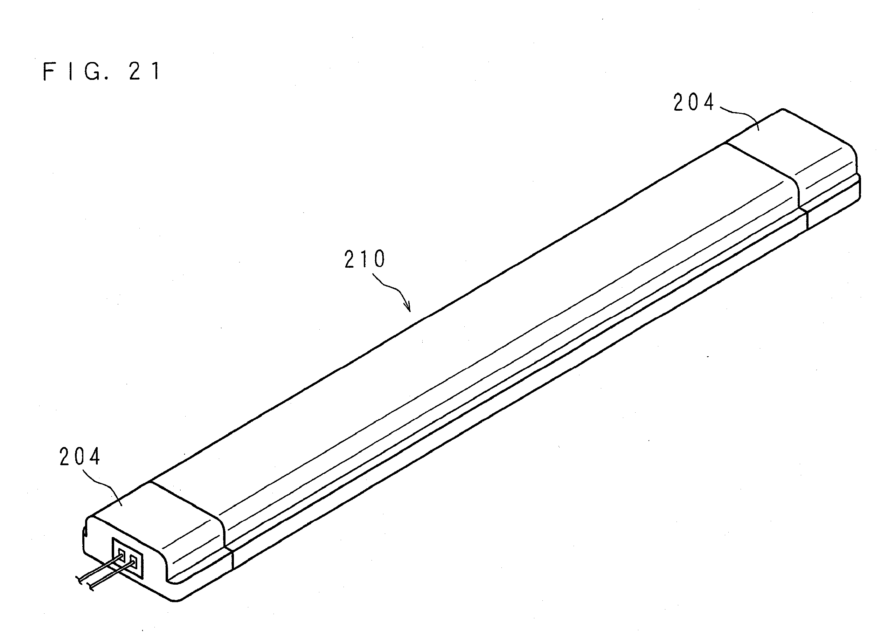

FIG. 21 is a perspective view illustrating the appearance of the lighting section 201 of the illuminating apparatus of Embodiment 5. The lighting section 201 of the illuminating apparatus of Embodiment 5 includes a main body 210 (flat body) in a flat, long and narrow plate shape and covers 204 provided at the both ends of the main body 210.

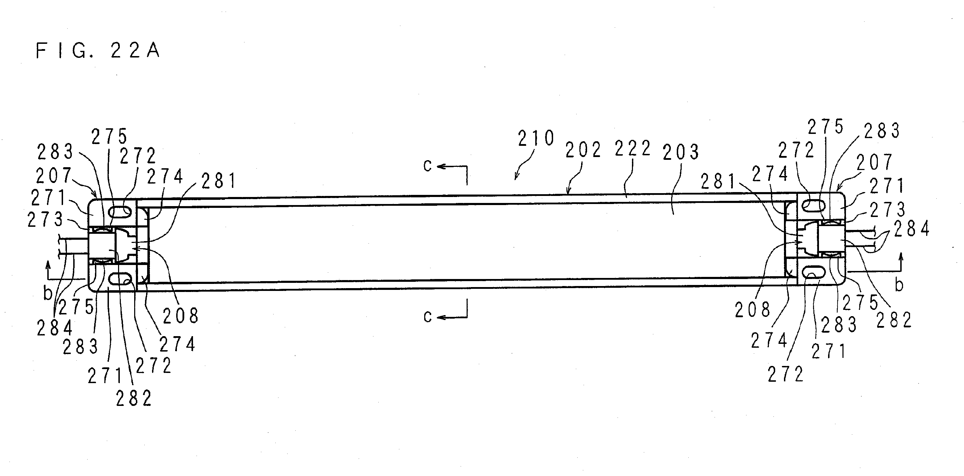

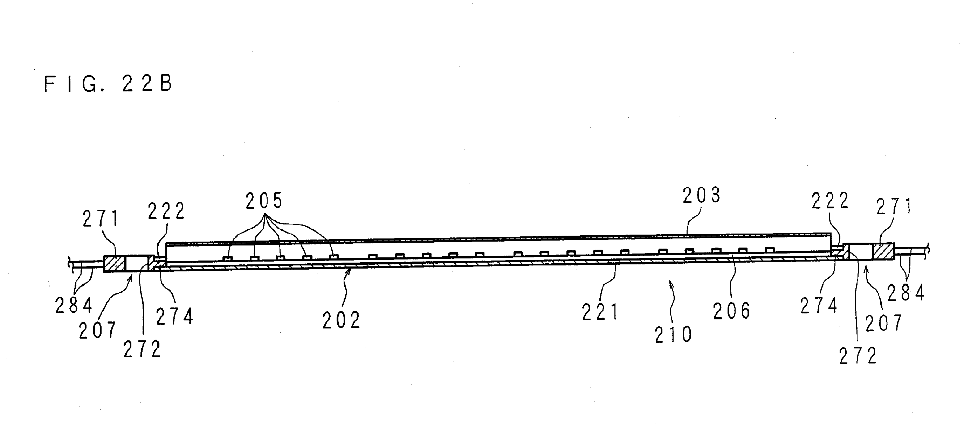

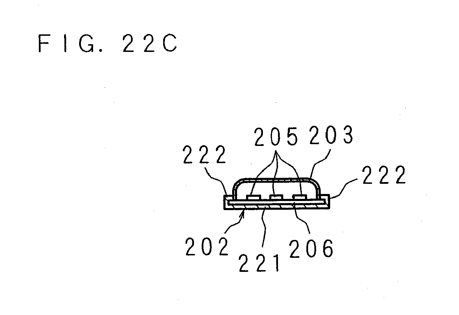

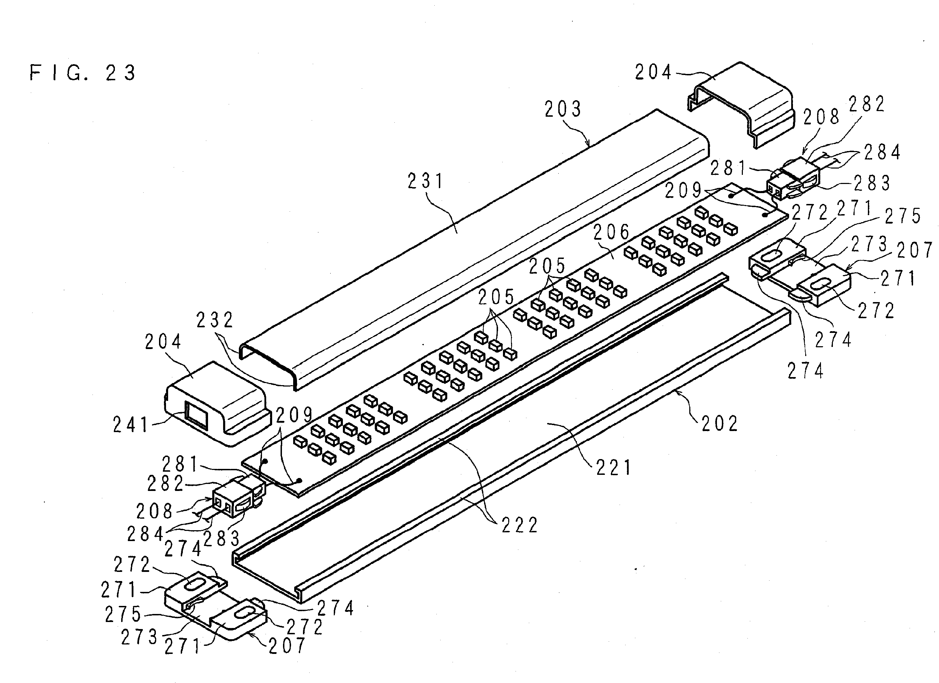

FIGS. 22A through 22C are schematic diagrams illustrating the lighting section 201 of the illuminating apparatus of Embodiment 5 from which the covers 204 are removed, and FIG. 23 is an exploded perspective view thereof. In the lighting section 201, a plurality of LEDs 205 are mounted in a plurality of rows on a rectangular substrate 206. The substrate 206 is housed in a housing section 202 in the shape of a long narrow trough slightly larger than the substrate 206, and clipping members 207 are fit in the both open ends of the housing section 202. A globe 203 covering the housing section 202 for uniformly diffusing light emitted from the LEDs 205 is in the shape of a tunnel and is grabbed on the housing section 202 so as to cover the substrate 206. The LEDs 205 are what is called multi chip white LEDs including red LEDs, green LEDs and blue LEDs. Furthermore, the red LEDs, the green LEDs and the blue LEDs can be respectively individually controlled for light-emission by the control section 220.

The substrate 206 having a first face on which the LEDs 205 are mounted is in a long narrow rectangular shape. In both end portions in the lengthwise direction of the substrate 206 on its mounting face on which the LEDs 205 are mounted, a pair of lead wires 209 for supplying power to the LEDs 205 and signal lines (not shown) for sending an instruction signal to the control section 220 are provided. A first end of each of the lead wires 209 and the signal lines are soldered on the substrate 206 and a second end thereof is connected to the connecting member 208. Each of the lead wires 209 has a length of, for example, approximately 10 mm. Since the substrate 206 is connected to the connecting members 208 through the lead wires 209, the substrate 206 can be prevented from being directly damaged by impact, tensile force or the like externally applied to the connecting members 208. In other words, when impact, tensile force or the like is externally applied to the connecting members 208, the lead wires 209 connected to the connecting members 208 are modified, broken or the like for reducing the applied force, so as to suppress damage of the substrate 206. The substrate 206 is supported with its both ends of the longer sides fit in the housing section 202.

The housing section 202 is in the shape of a trough. The housing section 202 includes an attaching plate 221 that is in a long narrow rectangular shape similar to the substrate 206 and has a first face opposing an installation surface and engaging grooves 222 in which the both ends of the longer sides of the substrate 206 are fit. The attaching plate 221 has a length larger than that of the substrate 206 and has a width slightly larger than that of the substrate 206. The engaging grooves 222 are provided on sides of the both longer sides of the attaching plate 221, and the substrate 206 is guided by the engaging grooves 222 to be fit and engaged on the housing section 202 with the face of the substrate 206 on which the LEDs are not mounted opposing a second face of the attaching plate 221. Accordingly, when disconnection or the like of a wire is caused, or when the lighting section 201 is exchanged in accordance with an operating characteristic, the substrate 206 can be drawn out from the housing section 202 for repair, exchange or the like. The attaching plate 221 and the engaging grooves 222 are made of aluminum and integrally formed.

The both open ends of the housing section 202 are caught by the clipping members 207 with the first face opposing the installation surface. Each of the clipping members 207 includes attaching parts 271 each in the shape of a rectangular parallelepiped having a through hole 272 through which the clipping member 207 is screwed onto the installation surface, and a placing plate 273 on which the connecting member 208 is placed. The placing plate 273 is in a rectangular shape and has the same thickness as the attaching plate 221 of the housing section 202. The attaching parts 271 are disposed to oppose each other and provided on sides of the longer sides of the placing plate 273. The attaching parts 271 and the placing plate 273 are made of a plastic and are integrally formed so that the attaching parts 271 and the placing plate 273 have their faces opposing the installation surface at the same level. Each of the through holes 272 of the attaching parts 271 is a long hole having a major axis extending in a direction along the longer sides of the placing plate 273.

Furthermore, the attaching parts 271 of each of the clipping members 207 are provided with engaging projections 275 for catching the connecting member 208 between their opposing faces. On the other hand, the attaching parts 271 have, on their housing section side faces opposing the housing section 202, clipping flanges 274 for fixing the housing section 202 on the installation surface. The clipping flanges 274 are provided on the housing section side faces in positions away from the edges close to the installation surface by a distance corresponding to the thickness of the placing plate 273. When the lighting section 201 of the illuminating apparatus of Embodiment 5 is installed, with the clipping flanges 274 brought into contact with the end faces in the lengthwise direction of the attaching plate 221, the clipping members 207 are screwed onto the installation surface with screws inserted through the through holes 272, and thus, the housing section 202 is attached on the installation surface. In other words, the both ends in the lengthwise direction of the attaching plate 221 of the housing section 202 are caught between the clipping flanges 274 of the clipping member 207 and the installation surface.

The globe 203 is in the shape of a tunnel, covers the substrate 206, diffuses the light emitted from the LEDs 205 and transmits the light uniformly to the outside. The globe 203 includes a flat plate 231 in a rectangular shape similar to the substrate 206, and bent plates 232 extending gradually from the edges of the both longer sides of the flat plate 231 toward a direction perpendicular to the flat plate 231. The flat plate 231 and the bent plates 232 are made of semitranslucent polycarbonate with high shock resistance and high heat resistance and are integrally formed. The globe 203 is attached with the edges of the bent plates 232 fit in the engaging grooves 222 of the housing section 202.

Each of the connecting members 208 includes a female part 281 in the shape of a substantially square pole connected to the second end of the lead wire 209 and a male part 282 in the shape of a substantially square pole connected to the outside through a wire 284. The female part 281 is provided with engaged projections 283 to be engaged with the engaging projections 275 in positions corresponding to the engaging projections 275 when the connecting member 208 is placed on the placing plate 273 of the clipping member 207. The female part 281 and the male part 282 are removably connected to each other. Specifically, the female part 281 is caught by the clipping member 207, and the male part 282 is removably connected to the female part 281 through a notch 241 of the cover 204 described later.

In order to prevent the appearance of the illuminating apparatus from degrading due to exposure of the clipping members 207, the covers 204 are provided so as to cover the clipping members 207. Each of the covers 204 is attached to be continued in the lengthwise direction of the globe 203 and the housing section 202. Furthermore, each of the covers 204 has, on a side opposite to the globe 203 and the housing section 202, the notch 241 in a square shape for inserting the male part 282 of the connecting member 208.

The operation section 230 is provided with three buttons (not shown), that is, a "white light" button for use in maintenance of the apparatus, for keeping things in a working space or the like; a "wavelength control light" button for use in a patterning operation or the like; and an "OFF" button for cutting off the power. When the control section 220 accepts an instruction issued by an operator operating the operation section 230, namely, any of the three buttons, it controls power supply to the red LEDs, the green LEDs and blue LEDs of the lighting sections 201.

Although the control section 220 is provided within the illuminating apparatus in this embodiment, it may be provided in the operation section 230. Furthermore, when a plurality of illuminating apparatuses are connected to one another in the lighting equipment, the plural illuminating apparatuses may be controlled as a whole by the control section 220 provided within the operation section 230.

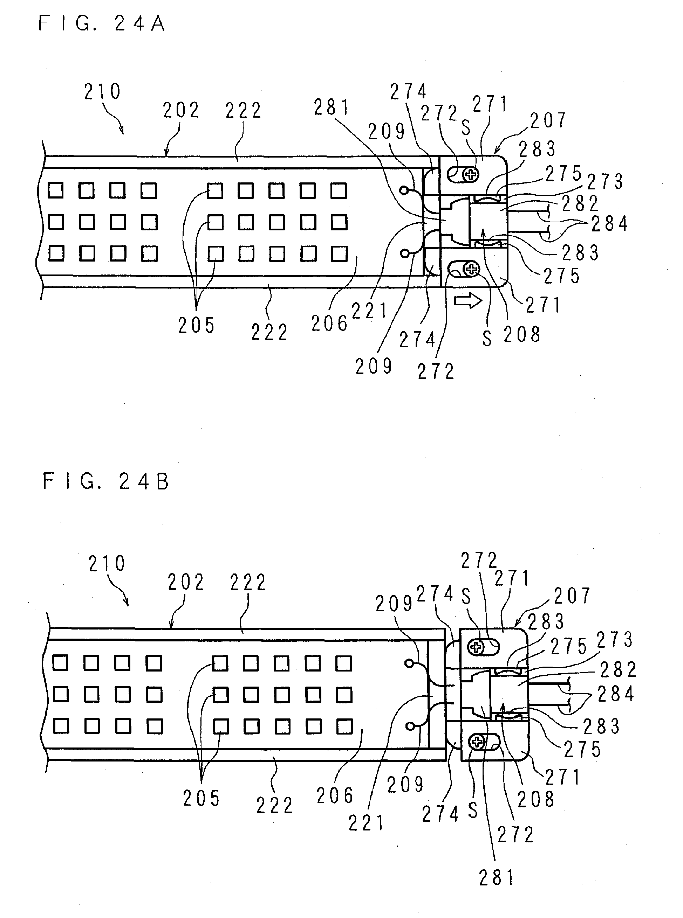

Now, an exchange operation for the substrate 206 in the illuminating apparatus of Embodiment 5 will be described. FIGS. 24A and 24B are explanatory diagrams explaining handling of the clipping members 207 in the exchange operation for the substrate 206. FIG. 24A illustrates a state attained before the handling of the clipping members 207 and FIG. 24B illustrates a state attained after the handling of the clipping members 207. For convenience, the globe 203 is omitted in these drawings, and merely one end portion out of the two end portions of the lighting section 201 is illustrated.

For the exchange operation for the substrate 206, the covers 204 are first removed. Before the exchange operation for the substrate 206, as illustrated in FIG. 24A, the both ends in the lengthwise direction of the attaching plates 221 of the housing section 202 are caught between the clipping flanges 274 of the clipping members 207 and the installation surface, so as to attach the main body 210 onto the installation surface.

Next, the lead wires 209 are disconnected from the connecting members 208. Thereafter, the screws S are turned so as to loosen the screws to an extent that the clipping members 207 have some play. Since the screws S are inserted through the through holes 272 each in the shape of a long hole, the clipping members 207 can be thus moved in the major axis direction of the through holes 272 (i.e., a direction indicated by a white arrow in FIG. 24A). As a result, the clipping flanges 274 of the clipping members 207 are not in contact-with the ends in the lengthwise direction of the attaching plate 221 of the housing section 202, and hence, the catch of the housing section 202 (the attaching plate 221) by the clipping flanges 274 is released (as illustrated in FIG. 24B).

Through this operation, the main body 210 alone can be removed from the installation surface. Subsequently, the globe 203 is removed, and the substrate 206 is drawn out from the housing section 202 for an operation of exchange with a new substrate, repair of disconnection or the like.

### (EMBODIMENT 6)

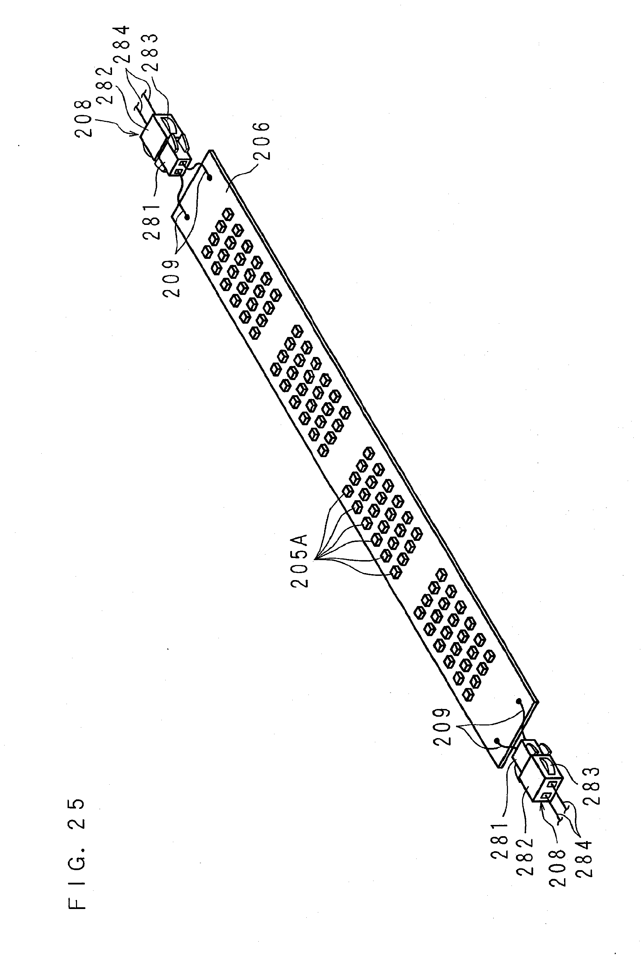

FIG. 25 is a perspective view of LEDs 205A and a substrate 206 of a lighting section 201 and connecting members 208 of an illuminating apparatus according to Embodiment 6 of the invention. It is noted that like reference numerals are used to refer to like elements used in Embodiment 5 and the detailed description is omitted.

In the lighting section 201 of the illuminating apparatus of Embodiment 6, a plurality of LEDs 205A are mounted in a plurality of rows on the rectangular substrate 206. The LEDs 205A are what is called multi chip white LEDs including red LEDs, green LEDs and blue LEDs. Furthermore, a yellow phosphor to be excited by light of a blue LED is applied on each blue LED (not shown). For example, the blue LED is an InGaN-based LED, and the yellow phosphor is a BOS phosphor, (BaSr)2SiO₂: Eu2+ or a Ce: YAG (cerium activated yttrium aluminum garnet) phosphor. Since the yellow phosphor reacts to the light of the blue LED so as to suppress the light emission of the blue LED, the g-line (of a wavelength of 436 nm) generated when the blue LED emits the light is also suppressed.

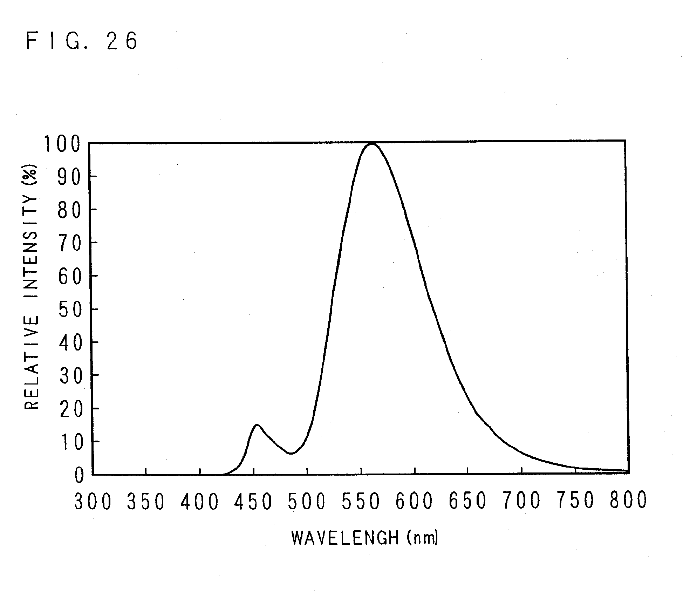

FIG. 26 is a graph illustrating a spectrum obtained by turning on the lighting section 201 of the illuminating apparatus of Embodiment 6. Light of the i-line (of a wavelength of 365 nm) is not emitted, and light of the g-line (of a wavelength of 436 nm) is slightly observed but almost cut. Accordingly, no problem is caused in a patterning operation using a photoresist, a UV resin or the like optically reacted to the i-line and the g-line. Incidentally, since white light emitted by the blue LEDs and the yellow phosphor and a yellow (lemon yellow) light obtained as a mixture of light of the red LEDs and light of the green LEDs are mixed, a room where this illuminating apparatus is installed is illuminated with bright yellow light more close to white light, an operator can perform a patterning operation in a bright work environment under no stress.

Although the yellow phosphor is used as the phosphor reacted to the light of the blue LEDs for suppressing the light emission of the blue LED in the lighting section 201 of the illuminating apparatus of Embodiment 6, the phosphor is not limited to this but may be, instead of the yellow phosphor, a red phosphor of, for example, Sr₂Si₅N₈: Eu or CaAlSiN: Eu2+.

### (EMBODIMENT 7)

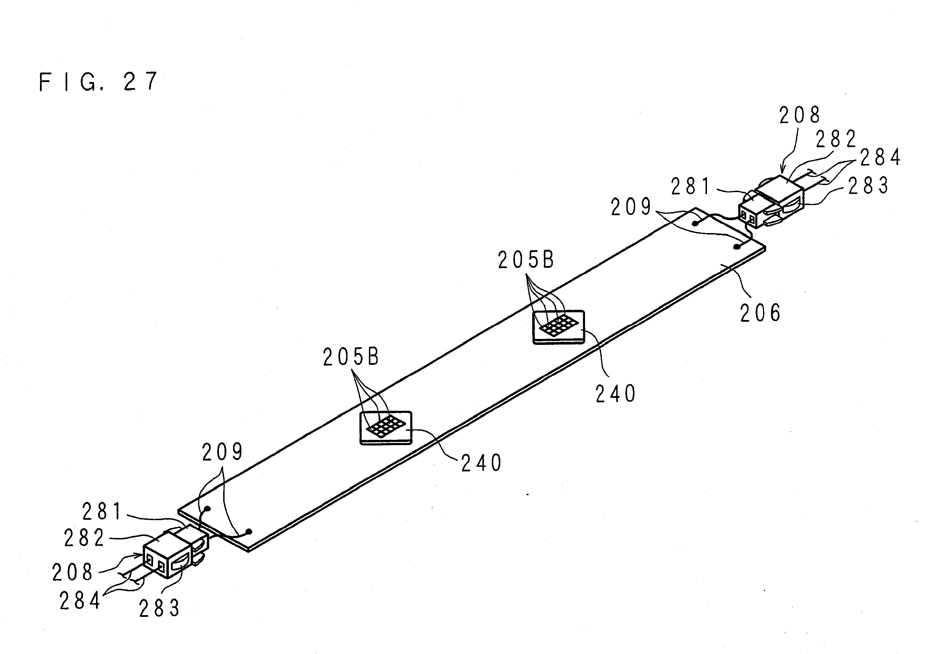

FIG. 27 is a perspective view of LED modules 240 and a substrate 206 of a lighting section 201 and connecting members 208 of an illuminating apparatus according to Embodiment 7 of the invention. It is noted that like reference numerals are used to refer to like elements used in Embodiments 5 and 6 and the detailed description is omitted.

In the lighting section 201 of the illuminating apparatus of Embodiment 7, the two LED modules 240 are attached onto the substrate 206 to be appropriately spaced from each other in the lengthwise direction of the substrate 206. In each of the LED modules 240, a plurality of LEDs 205B (small chips) of 0.1 W are closely mounted in a center on a front face of a rectangular ceramic substrate. Through holes (not shown) for screwing are formed on any of two opposing apexes of the ceramic substrate, so as to screw the LED modules 240 onto the substrate 206.

The LEDs 205B are what is called multi chip white LEDs including red LEDs, green LEDs and blue LEDs. Furthermore, the red LEDs, the green LEDs and the blue LEDs are individually controlled for light emission.

Although the illuminating apparatus including the red LEDs, the green LEDs and the blue LEDs is described in Embodiment 6 or 7, the illuminating apparatus may include the blue LEDs alone and the yellow phosphor. When the amount of yellow phosphor is increased for adjustment, the probability that the light emitted from the blue LEDs is converted in the wavelength by the yellow phosphor is increased, so as to suppress blue light of a wavelength of the g-line (of a wavelength of 436 nm).

Even composite light of blue light emitted from the blue LEDs and yellow light emitted from the yellow phosphor can be bright yellow (lemon yellow) light close to white light, and owing to this lemon yellow light, an operator can perform a patterning operation in a bright work environment under no stress. In this case, the yellow phosphor prevents a photosensitive reaction of a photosensitive material, and hence, it works as a control section for suppressing a specific wavelength.

### (EMBODIMENT 8)

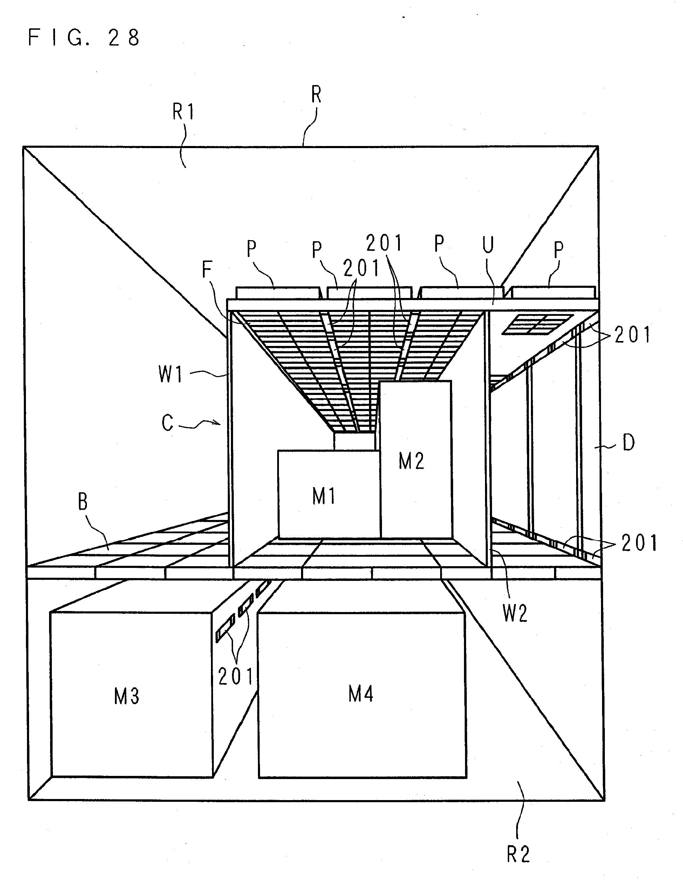

A clean room equipped with any of the aforementioned illuminating apparatuses will now be described. In the following exemplary description, a case in which the illuminating apparatus according to Embodiment 5 is installed will be described. FIG. 28 is a transparent perspective view of the inside of a clean room C where the illuminating apparatus is installed. A room R is partitioned by a mesh base plate B into an upper space R1 and a lower space R2. Apparatuses M1 and M2 are installed in the space R1, and apparatuses M3 and M4 opposing each other are installed in the space R2.

The space R1 includes a clean room C partitioned by a partition wall W1 and a partition wall W2 both of which are in a rectangular shape with the same dimension and protrude from the base plate B in the vertical direction. A corridor D is formed between one side wall of the room R opposing the partition wall W2 and the partition wall W2. A ceiling plate U is provided on a ceiling side over the clean room C and the corridor D. On the inside of the ceiling plate U in the clean room C, HEPA filters F are attached substantially all over. The HEPA filters F are suspended with their edges in contact with a frame of what is called a fan filter unit. On the other hand, on the inside of the ceiling plate U in the corridor D, the HEPA filter F is merely partly provided.

On the outside of the ceiling plate U, a plurality of circulating fans P for sending air into the clean room C and the corridor D are provided. The air sent by the circulating fans P into the clean room C and the corridor D is subjected to filtration for dust by the HEPA filters F. The air having entered the clean room C and the corridor D flows out of the clean room C and the corridor D through the base plate B. Air present outside the clean room C and the corridor D is sent again by the circulating fans P into the clean room C and the corridor D. Accordingly, constant air flow is caused in the clean room C.

In the clean room C, a plurality of lighting sections 201 each in a long narrow shape are arranged in two rows along the lengthwise direction on a lower face of the frame of the fan filter unit, so as to illuminate the inside of the clean room C. On the other hand, in the corridor D, a plurality of lighting sections 201 are arranged on the side wall of the room R along the ceiling plate U and the base plate B, so as to illuminate the corridor D and step of a walker.

On the other hand, on the apparatus M3 installed in the space R2, a plurality of lighting sections 201 are arranged to be appropriately spaced from one another along the lengthwise direction in an upper portion of its face opposing the apparatus M4, so as to illuminate a narrow space formed between the apparatus M3 and the apparatus M4.

As described above, since there is constant air flow in the clean room C, protrusion from the installation surface of an illuminating apparatus to be installed in the clean room C is preferably small. When the protrusion is large, the air flow is disturbed, resulting in a problem that the air does not flow well and hence dust is collected in the vicinity of the illuminating apparatus. Since the lighting section 201 of the illuminating apparatus of, for example, Embodiment 5 has the aforementioned structure, the protrusion from the installation surface can be suppressed small, so as to reduce the occurrence of this problem. Furthermore, when the lighting section 201 is provided in the corridor D, since the protrusion from the installation surface is small, passage of a walker is not disturbed.

The illuminating apparatus is preferably installed on a beam supporting a plurality of HEPA filters F. Since the illuminating apparatus of this invention is compact, there is no need to separately provide a space for the illuminating apparatus on a ceiling, and the ratio in the ceiling surface occupied by the HEPA filters can be increased.

A conventional illuminating apparatus such as a fluorescent light or a mercury lamp provided with a filter for cutting a specific wavelength has a large size in a lighting portion, and therefore, it is necessary to secure a space for installing the lighting portion on the ceiling, which reduces the area occupied by HEPA filters. Furthermore, due to the space occupied by the illuminating apparatus such as a fluorescent light or a mercury lamp installed between the HEPA filters on the ceiling, a space with no air flow is caused in the vicinity of the illuminating apparatus, and hence, dust floating in the air cannot be sufficiently removed. As a result, the efficiency for cleaning the inside of the clean room is disadvantageously low.

Since the illuminating apparatus of this invention uses an LED as a light source, it is a thinner illuminating apparatus than the conventional illuminating apparatus such as a fluorescent light or a mercury lamp, and hence, the air flow circulating within the room is not disturbed. As a result, dust can be prevented from remaining in the air due to staying air flow but can be carried to the floor to be circulated and filtrated by the HEPA filters.

Moreover, since the illuminating apparatus is thin and light, a place for installing the illuminating apparatus is not limited to the ceiling but it may be installed on a wall or on an apparatus used in the room. Therefore, in accordance with the environment within the room and the contents of an operation to be performed, the illuminating apparatus can be appropriately changed in the number or in the installation place, and change in the layout in a factory can be easily coped with.

In the following description, control of the lighting sections 201 will be described, for convenience in explanation, dividedly with respect to a case of performing what is called a patterning operation for transferring a fine circuit pattern by using a photoresist having a physical property such as solubility changed through exposure to light of the g-line (of a wavelength of 436 nm) or the i-line (of a wavelength of 365 nm) and what is called an adhering operation using a UV resin or the like having a curing physical property, and a case of performing maintenance of a patterning system.

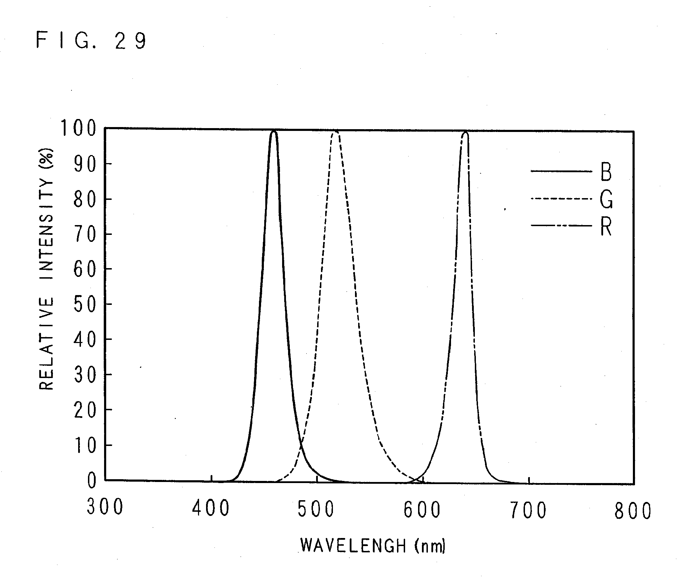

First, in the case where the maintenance of the patterning system is performed, an operator operates the "white light" button of the operation section 230. The control sections 220 having accepted an instruction through the operation of the "white light" button supply power to the red LEDs, the green LEDs and the blue LEDs of the lighting sections 201 so as to allow white light to be emitted. FIG. 29 is a graph illustrating spectra obtained by turning on a red LED, a green LED and a blue LED. The abscissa of the graph indicates relative intensity, and the ordinate indicates the wavelength (nm). In this drawing, a peak having a maximum value in the vicinity of 460 nm illustrated with a solid line is derived from light of the blue LED, a peak having a maximum value in the vicinity of 510 nm illustrated with a broken line is derived from light of the green LED, and a peak having a maximum value in the vicinity of 650 nm illustrated with an alternate long and two dashes line is derived from light of the red LED.

As illustrated in FIG. 29, light of the i-line (of a wavelength of 365 nm) is not emitted but light of the g-line (of a wavelength of 436 nm) is slightly emitted. However, an operation using a photoresist, a UV resin or the like optically reacted to the i-line and the g-line is not performed in this case, and hence, there arises no problem in the operation. Incidentally, the inside of the clean room C is illuminated brightly with white light obtained by mixing the light of the red LEDs, the light of the green LEDs and the light of the blue LEDs, and hence, the operator can perform the maintenance of the patterning system in a bright work environment.

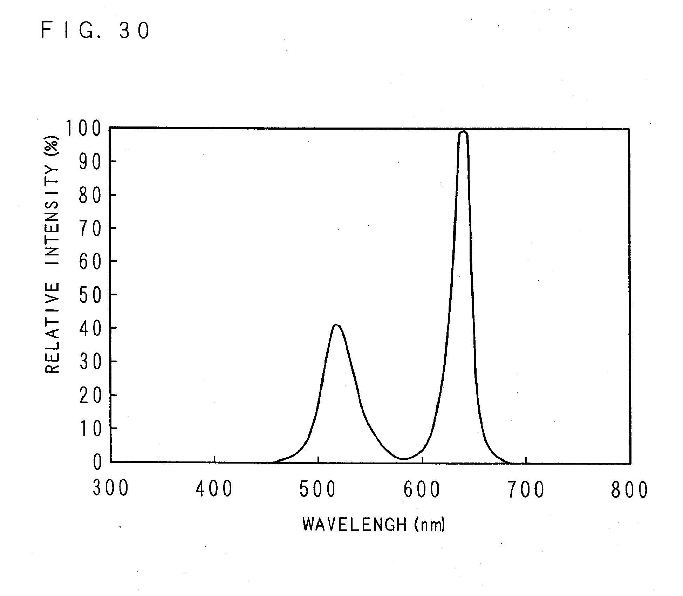

On the other hand, after completing the maintenance of the patterning system, when the patterning operation is to be performed by using a photoresist, a UV resin or the like, the operator operates the "wavelength control light" button of the operation section 230. The control sections 220 having accepted an instruction through the operation of the "wavelength control light" button supply power merely to the red LEDs and the green LEDs of the lighting sections 201. FIG. 30 is a graph illustrating spectra obtained by turning on a red LED and a green LED alone. The abscissa of the graph indicates relative intensity, and the ordinate indicates the wavelength (nm). As is obvious from FIGS. 29 and 30, the peak in the vicinity of the g-line (of a wavelength of 436 nm), which is present when the red LED, the green LED and the blue LED are turned on, is completely eliminated.

Accordingly, the light of the i-line and the g-line is completely cut, and hence, there arises no problem in the patterning operation using a photoresist, a UV resin or the like optically reacted to the i-line and the g-line. Incidentally, the inside of the clean room C is brightly illuminated with yellow (lemon yellow) light obtained by mixing the light of the red LEDs and the light of the green LEDs. At this point, the yellow is bright yellow close to white specified in the xy chromaticity diagram by an x value of 0.38 through 0.44 and a y value of 0.48 through 0.54, and hence, the operator can perform the patterning operation in a bright work environment under no stress.

In the above description, the control sections 220 supply the power to the red LEDs, the green LEDs and the blue LEDs of the respective lighting sections 201 and supply the power to the red LEDs and the green LEDs alone, which does not limit the invention. It is possible, if necessary, to employ a structure also capable of what is called single wavelength lighting by individually using the red LEDs, the green LEDs and the blue LEDs.

Although the control by restricting the power supply to the blue LEDs is exemplarily described above, the control is not limited to this. For example, the same effects can be attained by PWM (Pulse Width Modulation) control of the red LEDs, the green LEDs and the blue LEDs. When the PWM control is performed, the color of light obtained by mixing the light of the red LEDs and the light of the green LEDs can be adjusted.

Furthermore, each illuminating apparatus includes the control section 220 in the above description, which does not limit the invention. For example, a structure in which one control section 220 can control the red LEDs, the green LEDs and the blue LEDs of the plural lighting sections 201 may be employed instead.

On the other hand, the lighting sections 201 provided in the corridor D may illuminate with white light obtained by always turning on the red LEDs, the green LEDs and the blue LEDs, so as to allow merely one type of the LEDs to be turned on in an emergency.

## Claims

1. A light emitting device comprising:
a semiconductor light emitting element; and
an inhibitor for suppressing a specific wavelength component to which a photosensitive material is sensitive.

2. A light emitting device comprising:
a semiconductor light emitting element;
a phosphor to be excited by light emitted from the semiconductor light emitting element; and
an encapsulating resin including the phosphor and covering the semiconductor light emitting element,
wherein the phosphor included in the encapsulating resin suppresses a specific wavelength component for preventing a photosensitive material sensitive to the specific wavelength component from reacting.

3. The light emitting device according to claim 1 or 2, wherein a wavelength region to which the photosensitive material is sensitive is a blue region of g-line.

4. The light emitting device according to claim 2 or 3, wherein an amount of the phosphor is larger than an amount of phosphor to be included in an encapsulating resin when the light emitting device emits white light.

5. The light emitting device according to any of claims 1 through 4,
wherein the semiconductor light emitting element is a light emitting diode.

6. The light emitting device according to claim 5,
wherein the light emitting diode is a blue light emitting diode and the phosphor is a yellow phosphor.

7. The light emitting device according to any of claims 1 through 6,
wherein light emitted from the light emitting device has a color coordinate x in an xy chromaticity diagram with a value of 0.4 through 0.45.

8. The light emitting device according to any of claims 2 through 7,
wherein the encapsulating resin includes a red phosphor.

9. An illuminating apparatus comprising the light emitting device of any of claims 1 through 8.

10. The illuminating apparatus according to claim 9, further comprising blocking means for blocking light with the specific wavelength component.

11. The illuminating apparatus according to claim 10,
wherein the blocking means includes a filter for blocking light with the specific wavelength component and a diffuser panel.

12. The illuminating apparatus according to claim 11,
wherein the blocking means includes an air gap between the filter and the diffuser panel.

13. An illuminating apparatus comprising:
a plurality of semiconductor light emitting elements; and
a control section for suppressing a specific wavelength for preventing a photosensitive material sensitive to the specific wavelength from reacting.

14. An illuminating apparatus comprising:
a plurality of semiconductor light emitting elements,
wherein the plurality of semiconductor light emitting elements are controlled for performing illumination with white light and performing illumination in which a specific wavelength is suppressed for preventing a photosensitive material sensitive to the specific wavelength from reacting.

15. The illuminating apparatus according to claim 13 or 14,
wherein the plurality of semiconductor light emitting elements include green light emitting diodes and red light emitting diodes, and
light obtained by mixing light of the green light emitting diodes and light of the red light emitting diodes is emitted.

16. The illuminating apparatus according to claim 15,
wherein the light has a color specified in an xy chromaticity diagram by an x value of 0.38 through 0.44 and a y value of 0.48 through 0.54.

17. The illuminating apparatus according to claim 15,
wherein the plurality of semiconductor light emitting elements further include blue light emitting diodes, and
the illuminating apparatus further comprises a control section for controlling individual light emission of the green light emitting diodes, the red light emitting diodes and the blue light emitting diodes and combined light emission of the green light emitting diodes, the red light emitting diodes and the blue light emitting diodes.

18. The illuminating apparatus according to any of claims 13 through 17,
wherein a yellow phosphor layer or a red phosphor layer is formed on a part or all of the plurality of semiconductor light emitting elements.

19. The illuminating apparatus according to any of claims 13 through 18, further comprising:
a substrate on which the plurality of semiconductor light emitting elements are mounted;
a housing section for housing the substrate; and
a translucent section attached on the housing section for transmitting light emitted from the plurality of semiconductor light emitting elements,
wherein the translucent section and the housing section together form a flat body when the translucent section is attached on the housing section.

20. A clean room comprising the illuminating apparatus of any of claims 9 through 19.
